(19) **Europäisches Patentamt / European Patent Office / Office européen des brevets**

(11) **EP 2 114 675 B1**

(12) # EUROPÄISCHE PATENTSCHRIFT

(45) Veröffentlichungstag und Bekanntmachung des Hinweises auf die Patenterteilung:
**01.02.2012 Patentblatt 2012/05**

(21) Anmeldenummer: **08708810.0**

(22) Anmeldetag: **08.02.2008**

(51) Int Cl.:
**B41C 1/05** *(2006.01)* **G03F 7/027** *(2006.01)*

(86) Internationale Anmeldenummer:
**PCT/EP2008/051534**

(87) Internationale Veröffentlichungsnummer:
**WO 2008/095994 (14.08.2008 Gazette 2008/33)**

(54) **FOTOPOLYMERISIERBARE FLEXODRUCKELEMENTE UND DARAUS HERGESTELLTE HARTE FLEXODRUCKFORMEN**

PHOTOPOLYMERIZABLE FLEXOGRAPHIC PRINTING ELEMENTS AND HARD FLEXOGRAPHIC PRINTING FORMES WHICH ARE PRODUCED THEREFROM

ÉLÉMENTS D'IMPRESSION FLEXOGRAPHIQUE PHOTOPOLYMÉRISABLES ET FORMES D'IMPRESSION FLEXOGRAPHIQUE DURES FABRIQUÉES À PARTIR DE CEUX-CI

(84) Benannte Vertragsstaaten:
**AT BE BG CH CY CZ DE DK EE ES FI FR GB GR HR HU IE IS IT LI LT LU LV MC MT NL NO PL PT RO SE SI SK TR**

(30) Priorität: **08.02.2007 DE 102007006378**

(43) Veröffentlichungstag der Anmeldung:
**11.11.2009 Patentblatt 2009/46**

(73) Patentinhaber: **Flint Group Germany GmbH**
**70469 Stuttgart (DE)**

(72) Erfinder:
• **BECKER, Armin**
**67259 Grossniedesheim (DE)**
• **STEBANI, Uwe**
**67592 Flörsheim-Dalsheim (DE)**
• **GEISEN, Berthold**
**73760 Ostfildern (DE)**
• **KRAUSS, Uwe**
**76857 Gossersweiler-Stein (DE)**
• **TELSER, Thomas**
**69123 Heidelberg (DE)**

(74) Vertreter: **Schuck, Alexander**
**Isenbruck Bösl Hörschler LLP**
**Eastsite One**
**Seckenheimer Landstrasse 4**
**68163 Mannheim (DE)**

(56) Entgegenhaltungen:
**EP-A- 1 516 745 WO-A-2006/056413**

**Beschreibung**

Die Erfindung betrifft fotopolymerisierbare Flexodruckelemente, welche ethylenisch ungesättigte, alicyclische Monomere enthalten, sowie daraus herstellbare harte Flexodruckformen, insbesondere zylindrische, endlos-nahtlose Flexodruckformen.

Die Härte und die Dicke von Flexodruckformen richtet sich nach dem Bedruckstoff, welcher bedruckt werden soll. Während zum Bedrucken von weichen Bedruckstoffen wie Wellpappe oder Kartonagen relativ dicke und weiche Flexodruckformen eingesetzt werden, werden für den hochqualitativen Rasterdruck, beispielsweise zum Bedrucken von Kunststofffolien oder Papier, relativ dünne und harte Flexodruckformen eingesetzt. Für den qualitativ hochwertigen Rasterdruck geeignete Flexodruckformen sollten insbesondere einen hohen Tonwertumfang sowie eine geringe Tonwertzunahme aufweisen.

Flexodruckformen können Plattenform oder Zylinderform aufweisen. Bei einer zylindrischen Flexodruckform ist der Druckzylinder der Druckmaschine im gesamten Umfang mit einer Druckschicht bzw. einem Druckrelief versehen. Zylindrische Druckformen besitzen große Bedeutung für den Druck von Endlos-Mustern und werden beispielsweise zum Drucken von Tapeten, Dekorpapieren oder Geschenkpapieren verwendet. Sie werden jedoch auch für den Druck nicht endloser Motive verwendet, um mittels einer geschickten Anordnung mehrerer Nutzen eine möglichst hohe Wirtschaftlichkeit des Drucks zu erzielen.

Im Prinzip kann der eigentliche Druckzylinder der Druckmaschine selbst mit einer vollständig umhüllenden Druckschicht versehen werden. Diese Vorgehensweise hat jedoch den Nachteil, dass beim Wechsel der Druckform unter Umständen der gesamte Druckzylinder ausgetauscht werden muss. Dies ist äußerst aufwändig und dementsprechend teuer.

Üblich ist daher die Verwendung sogenannter Sleeves. Bei einem Sleeve handelt es sich um einen zylindrischen Hohlkörper, auch als Hülse bezeichnet, der mit einer Druckschicht bzw. einem Druckrelief versehen worden ist. Die Sleeve-Technik ermöglicht einen sehr schnellen und einfachen Wechsel der Druckform. Der Innendurchmesser der Sleeves entspricht dem Außendurchmesser des Druckzylinders, so dass die Sleeves einfach über den Druckzylinder der Druckmaschine geschoben werden können. Das Auf- und Abschieben der Sleeves funktioniert fast ausnahmslos nach dem Luftkissenprinzip: Für die Sleeve-Technologie ist die Druckmaschine mit einem speziellen Druckzylinder, einem sogenannten Luftzylinder, ausgestattet. Der Luftzylinder verfügt über einen Druckluftanschluss an der Stirnseite, mit dem Druckluft in das Innere des Zylinders geleitet werden kann. Von dort aus kann sie über an der Außenseite des Zylinders angeordnete Löcher wieder austreten. Zur Montage eines Sleeves wird Druckluft in den Luftzylinder eingeleitet und tritt an den Austrittslöchern wieder aus. Der Sleeve kann nun auf den Luftzylinder aufgeschoben werden, weil er sich unter dem Einfluss des Luftkissens geringfügig dehnt und das Luftkissen die Reibung deutlich vermindert. Wenn die Druckluftzufuhr beendet wird, geht die Dehnung zurück und der Sleeve sitzt auf der Oberfläche des Luftzylinders fest. Weitere Einzelheiten zur Sleeve-Technik sind beispielsweise offenbart in "Technik des Flexodrucks", S. 73 ff., Coating Verlag, St. Gallen, 1999.

Qualitativ hochwertige Runddruckformen können jedoch nicht hergestellt werden, indem man den Druckzylinder oder eine Hülse einfach mit einer bereits druckfertig verarbeiteten Flexodruckplatte vollständig umhüllt. An den zusammenstoßenden Enden der Druckplatte verbleibt nämlich ein feiner Spalt, welcher bei echten Endlos-Motiven oder versetztem Nutzen immer auch druckende Bereiche der Platte durchschneidet. Dieser Spalt führt zu einer deutlich sichtbaren Linie im Druckbild. Um diese Linie zu vermeiden, dürfen sich an dieser Stelle nur nicht druckende Vertiefungen befinden, und somit können nicht beliebige Muster gedruckt werden. Außerdem besteht bei dieser Technik die Gefahr, dass das in der Druckfarbe enthaltene Lösungsmittel in den Spalt eindringen und die Enden der Druckplatte vom Druckzylinder loslösen kann. Dies führt zu noch stärkeren Störungen im Druckbild. Auch bei einem Verkleben der Enden verbleiben noch deutlich sichtbare Spuren im Druckbild.

Zur Herstellung qualitativ hochwertiger Runddruckformen ist es daher erforderlich, den Druckzylinder oder eine Hülse mittels geeigneter Techniken mit einer vollständig umhüllenden, reliefbildenden, fotopolymerisierbaren Schicht zu versehen. Dies kann beispielsweise durch Beschichten aus Lösung oder durch Ringextrusion erfolgen. Beide Techniken sind jedoch äußerst aufwändig und daher entsprechend teuer. Insbesondere muss bei diesen Techniken im Regelfall für jeden neuen Außendurchmesser ein eigenes, hochpräzises Werkzeug hergestellt und eingesetzt werden. Es ist daher weit verbreitet, den Druckzylinder oder die Hülse mit einer vorgefertigten, thermoplastisch verarbeitbaren Schicht aus fotopolymerisierbarem Material zu umwickeln und die zusammenstoßenden Kanten der fotopolymerisierbaren Schicht, auch Naht genannt, mittels geeigneter Techniken so gut wie möglich zu verschließen. Erst in einem zweiten Schritt wird das zylindrische fotopolymerisierbare Flexodruckelement zur fertigen Runddruckform verarbeitet.

Bei der Herstellung von fotopolymerisierbaren Flexodruckelementen unter Verwendung von vorgefertigten Schichten ist es von besonderer Bedeutung, die Naht vollständig und mit äußerster Präzision zu verschließen. Die Bedeutung dieses Verfahrensschrittes hat in den letzten Jahren noch zugenommen. Moderne fotopolymerisierbare Flexodruckelemente, wie beispielsweise digital bebilderbare Flexodruckelemente, erlauben die Herstellung von Flexodruckformen mit deutlich höherer Auflösung als dies früher der Fall war. Flexodruck dringt daher auch zunehmend in solche Bereiche ein, die früher anderen Druckverfahren vorbehalten waren. Bei höherer Auflösung werden aber auch Fehler in der druckenden Oberfläche der Flexodruckform schneller sichtbar. Aus dem gleichen Grunde muss beim Aufbringen der fotopolymerisierbaren, reliefbildenden Schicht ebenfalls hohe Präzision gewährleistet sein. Dickenunterschiede in der reliefbildenden Schicht beeinträchtigen die Rundlaufgenauigkeit des Druckzylinders und damit die Druckqualität erheblich. Bei qualitativ hochwertigen Flexodruckformen sollte die Dickentoleranz üblicherweise nicht mehr als $\pm$ 10 $\mu$m betragen. Falls die Dickentoleranz der fotopolymerisierbaren Schicht des Sleeves nicht ausreichend ist, muss die Oberfläche des Sleeves nachgearbeitet werden. Eine derartige Vorgehensweise ist naturgemäß äußerst aufwendig, langwierig und unökonomisch.

Von WO 2004/092841 wurde daher ein verbessertes Verfahren zur Herstellung von zylindrischen, endlos-nahtlosen, fotopolymerisierbaren Flexodruckelementen vorgeschlagen, welches einen besseren Verschluss der Naht als bei den bekannten Technologien sowie eine sehr gute Rundlaufgenauigkeit gewährleistet. Auf diese Weise können in kurzer Zeit zylindrische, endlos-nahtlose fotopolymerisierbare Flexodruckelemente in hoher Qualität hergestellt werden. Der erzielbare Nahtverschluss ist sehr gut, ein Nacharbeiten des erhaltenen Flexodruckelementes durch aufwendige Schleif- und Glättvorgänge ist überflüssig. Das Verfahren umfasst dabei die folgenden Schritte:

a) Bereitstellen eines Schichtenverbundes mindestens umfassend eine Schicht aus einem fotopolymerisierbaren Material sowie eine von der Schicht abziehbare Trägerfolie,
b) Zurechtschneiden der zu verbindenden Kanten des Schichtenverbundes mittels Gehrungsschnitten,
c) Aufschieben und Arretieren des Hohlzylinders auf einen drehbar gelagerten Trägerzylinder,
d) Aufbringen einer Haftschicht auf die äußere Fläche des Hohlzylinders,
e) Aufbringen des zurechtgeschnittenen Schichtenverbundes mit der von der temporären Trägerfolie abgewandten Seite auf den mit der Haftschicht versehenen Hohlzylinder, wobei die mit dem Gehrungsschnitt versehenen Enden im Wesentlichen aufeinander liegen, aber nicht überlappen,
f) Abziehen der Trägerfolie von der Schicht aus fotopolymerisierbarem Material,
g) Verbinden der Schnittkanten bei einer Temperatur unterhalb der Schmelztemperatur der fotopolymerisierbaren Schicht, indem man die Oberfläche der fotopolymerisierbaren Schicht auf dem Hohlzylinder mit einer sich drehenden Kalanderwalze in Kontakt bringt, bis die Schnittkanten miteinander verbunden sind, und
h) Abziehen des bearbeiteten Hohlzylinders vom Trägerzylinder.

Zusammenfassend wird bei dem offenbarten Verfahren eine Schicht eines fotopolymerisierbaren Materials ohne Trägerfolie mittels einer geeigneten Haftschicht auf die äußere Fläche eines Hohlzylinders aufgebracht, deren Schichtenden dann anschließend durch Kalandrieren unter Wärmeeinwirkung spaltfrei verbunden werden.

Der Verzicht auf eine Trägerfolie ist für das von WO 2004/092841 offenbarte Verfahren unabdingbar, ist aber auch mit bestimmten Nachteilen hinsichtlich der erreichbare Härte der Flexodruckform, welche unter Verwendung des genannten Flexoduckelementes hergestellt wird, verbunden.

Die Härte der fertigen Druckform, die sogenannte Klischeehärte, wird nämlich sowohl durch die Härte der eigentlichen ausgehärteten, elastomeren Druckschicht sowie auch durch die Härte der Trägerfolie mitbestimmt. Der Einfluss der Trägerfolie ist hierbei naturgemäß umso größer, je dünner die elastomere Schicht ist. Beispielhaft sei hierbei verwiesen auf die nyloflex® ACE (Fa. Flint Deutschland GmbH), welche speziell für den qualitativ hochwertigen Rasterdruck empfohlen wird. Die Härte der ausgehärteten, elastomeren Schicht selbst (d.h. ohne den Träger), gemessen nach DIN 53505 an einer 6 mm dicken elastomeren Material beträgt 62° Shore A. Die Klischeehärte einschließlich der Trägerfolie (Dicke: 175 $\mu$m) beträgt bei einer Plattendicke von 2,84 mm 64° Shore A, bei 1,14 mm 79° Shore A und bei 0,76 mm 88° Shore A. Zieht man von der 1,14 mm dicken Platte die Trägerfolie ab, beträgt die Härte der verbliebenen elastomeren Schicht nur noch 73,6° Shore A. Diese reduzierte Härte führt im Druck zu einem geringeren Tonwertumfang im Vergleich zu der Platte mit Trägerfolie. Insbesondere für zylindrische Druckformen, bei denen die elastomere Schicht ohne zusätzliche Trägerfolie auf den zylindrischern Träger aufgebracht wird, ist es also äußerst wünschenswert, härtere elastomere Schichten einzusetzen. Um den genanten Verlust an Härte durch den Verzicht auf die Trägerfolie zu kompensieren zu können, ist es wünschenswert, Flexodruckformen zur Verfügung zu haben, deren Härte nach DIN 53505 (d.h. die Härte der elastomeren Schicht der fertigen Druckform ohne Trägerfolie, gemessen bei einer Schichtdicke von 6 mm) mindestens 66° Shore A beträgt.

Die Steigerung der Härte ist jedoch keineswegs trivial, denn es muss gleichzeitig gewährleistet sein, dass sich andere wichtige Eigenschaften der Flexodruckform im Zuge von Maßnahmen zur Steigerung der Härte nicht verschlechtern. Neben einer ausreichenden Härte der Druckform müssen weitere Randbedingungen erfüllt sein, damit ein sehr gutes Druckergebnis erzielt wird.

(1) Isotropes Verhalten der fertigen Druckform:

Die fertige Flexodruckform sollte sich isotrop verhalten, das heißt die mechanischen Eigenschaften und die Druckeigenschaften sollten unabhängig von der Orientierung des Flexodruckelementes in der Druckmaschine sein. Ein Maß für den Grad der Anisotropie ist der sogenannte Anisotropiefaktor AF. Die Realisierung härterer anisotropiefreier Platten ist deshalb nicht trivial, da die Neigung einer Druckform zu anisotropem Verhalten mit steigender Härte zunimmt. Beispielsweise lässt sich Verwendung üblicher Blockcopolymere aus Styrol und Butadien bzw. Isopren die Härte durch Verwendung von Bindemitteln mit höherem Styrolgehalt normalerweise steigern. Allerdings neigen Platten mit styrolreichen Bindemitteln stark zu Anisotropie. Dies kann daran liegen, dass sich in Blockcopolymeren mit geringeren Mengen an Styrol die Styrolphasen in der Regel als diskrete Inseln in einer Polyalkadienphase anordnen, bei größeren Mengen aber als zylinderförmige bzw. stäbchenförmige Phasen. Im Zuge der Flexodruckelementherstellung können sich die zylinderförmigen bzw. stäbchenförmigen Styrolphasen ausrichten, wodurch anisotropes Verhalten verursacht wird. Auch eine Reduktion des Weichmachergehalts führt zwar zu einer harten Platte, jedoch auch schnell zu anisotropem Verhalten.

(2) Rohschichtplastizität des Flexodruckelements:

Die Rohschichtplastizität (kalter Fluss) des noch unbelichteten, fotopolymerisierbaren Flexodruckelements sollte möglichst gering sein, da die Lagerung, Handhabung und die Verarbeitbarkeit zur Flexodruckform durch eine zu hohe Rohschichtplastizität signifikant erschwert werden. Bei einer zu hohen Rohschichtplastizität kann schon ein leichter Druck auf das Flexodruckelement, beispielsweise durch ungeschicktes Hantieren mit dem Flexodruckelement, zu einer irreversiblen Verformung der Schicht führen, so dass in Folge dessen eine völlig unbrauchbare Flexodruckform erhalten wird. Insbesondere wenn die Härte der Druckform durch eine höhere Monomerkonzentration in der fotopolymerisierbaren Schicht erreicht werden soll, führt eben diese höhere Monomerkonzentration zu einer signifikanten Steigerung der Rohschichtplastizität.

(3) Rundverarbeitbarkeit der fotopolymerisierbaren Schicht:

Das unbelichtete fotopolymerisierbare Flexodruckelement soll nach dem in WO 2004/092841 beschriebenen Verfahren rundverarbeitbar sein. Gute Rundverarbeitbarkeit korreliert mit dem Schmelzflussindex des fotopolymerisierbaren Flexodruckelements bei der Verarbeitungstemperatur. Je höher der Schmelzflussindex, desto besser rundverarbeitbar ist die Platte. Als Maß für die Rundverarbeitbarkeit wurde der Schmelzflussindex der fotopolymerisierbaren Schicht bei einer Temperatur von 100°C und einem Auflagegewicht von 5 kg herangezogen.

EP-A 1 516 745 offenbart eine photoempfindliche Zusammensetzung für ein lasergravierbares Druckelement umfassend ein Bindemittel, eine niedermolekulare polymerisierbare ungesättigte Verbindung sowie ein poröses anorganisches Material. Als Bindemittel werden SBS-, SIS- und SBR-Kautschuk genannt. Als niedermolekulare polymerisierbare Verbindung nennt die Beschreibung u.a. Cyclohexylmethacrylat. Die Beispiele 1 und 4 offenbaren Zusammensetzungen aus 100 Teilen SBS, 19 Teilen Cyclohexylmethacrylat und 5 Teilen eines anorganischen porösen Materials.

Aufgabe der Erfindung war es, verbesserte fotopolymerisierbare Flexodruckelemente bereitzustellen, welche zu Flexodruckformen mit größerer Härte verarbeitet werden können, insbesondere zu Flexodruckformen, bei denen die Shore A Härte der elastomeren Schicht mindestens 66° Shore A, gemessen nach DIN 53505 an einer 6 mm dicken Schicht ohne Trägerfolie beträgt, ohne dass dabei anisotrope Flexodruckelemente erhalten werden.

Aufgabe der Erfindung war es insbesondere, ein nach dem in WO 2004/092841 beschriebenen Verfahren herstellbares fotopolymerisierbares, zylindrisches endlos-nahtloses Flexodruckelement bereitzustellen, mit dem ein sehr gutes Druckergebnis erzielt wird. Insbesondere sollten die hergestellten Flexodruckformen beim Drucken eine geringe Tonwertzunahme und einen hohen Tonwertumfang ergeben und keine Anisotropie aufweisen. Die fotopolymerisierbare reliefbildende Schicht soll gut rundverarbeitbar und eine akzeptable Rohschichtplastizität aufweisen.

Überraschenderweise wurde gefunden, dass durch den Einsatz von speziellen Monomeren in der fotopolymerisierbaren, reliefbildenden Schicht härtere und dennoch im Wesentlichen anisotropiefreie Flexodruckelemente mit akzeptabler Rohschichtplastizität und dennoch guter Rundverarbeitbarkeit der fotopolymerisierbaren Schicht bereitgestellt werden.

Dementsprechend ist Gegenstand der Erfindung ein fotopolymerisierbares Flexodruckelement zur Herstellung von harten Flexodruckformen, mindestens umfassend

- einen dimensionsstabilen Träger,
- eine fotopolymerisierbare, reliefbildende Schicht enthaltend, jeweils bezogen auf die Gesamtmenge aller Komponenten der reliefbildenden Schicht,

  ■ 40 bis 90 Gew.-% eines Bindemittels enthaltend mindestens ein thermoplastisch-elastomeres Blockcopolymer umfassend mindestens einen aus einem Alkenylaromaten gebildeten Block und mindestens einen aus einem 1,3-Dien gebildeten Block,
  ■ 0,1 bis 20 Gew.% ethylenisch ungesättigte Monomere M,

■ 0,1 bis 5 Gew.% Fotoinitiator und

■ 1 bis 40 Gew.% Weichmacher,

dadurch gekennzeichnet,

dass die fotopolymerisierbare, reliefbildende Schicht als Monomere M mindestens ein Di(meth)acrylat M1 der allgemeinen Formel $H_2C=CR-C(O)O-R^2-OC(O)$ $CR=CH_2$, wobei R für H oder eine Methylgruppe steht, und es sich bei R2 um einen zweiwertigen acyclischen Kohlenwasserstoffrest mit 10 bis 20 Kohlenstoffatomen handelt, enthält und daneben gegebenenfalls noch ein oder mehrere weitere Monomere M2 enthalten kann, und die belichtete fotopolymerisierte reliefbildende Schicht eine Härte von mindestens 66° Shore A aufweist.

Bei den erfindungsgemäßen fotopolymerisierbaren Flexodruckelementen kann es sich sowohl um plattenförmige Flexodruckelemente als auch um zylindrische, bevorzugt endlos-nahtlose Flexodruckelemente handeln. In einer bevorzugten Ausführungsform der Erfindung handelt es sich bei den Flexodruckelementen um zylindrische Flexodruckelemente.

Gegenstand der vorliegenden Erfindung ist weiterhin ein Schichtverbund umfassend eine abziehbare, temporäre Trägerfolie, gegebenenfalls eine elastomere Trägerschicht, die fotopolymerisierbare, reliefbildende Schicht und eine abziehbare temporäre Deckfolie, zur Herstellung eines zylindrischen Flexodruckelements.

Als dimensionsstabile Träger kommen die aus der Flexodruckplattentechnik bekannten Träger in Frage, beispielsweise Platten, Folien oder zylindrische Röhren. Bei den Materialien der Träger kann es sich beispielsweise um Metalle, wie beispielsweise Stahl oder Aluminium oder um Kunststoffe wie beispielsweise Polyethylenterephalat, Polybutylenterephalat, Polyethylennaphthalat oder Polycarbonat handeln. Die Träger können optional mit üblichen haftvermittelnden Schichten behandelt sein.

Das in der fotopolymerisierbaren, reliefbildenden Schicht enthaltene fotopolymerisierbare Material umfasst mindestens ein thermoplastisch-elastomeres Blockcopolymer, mindestens ein ethylenisch ungesättigtes Monomer, mindestens einen Fotoinitiator sowie mindestens einen Weichmacher und optional weitere Komponenten.

Die thermoplastisch-elastomeren Blockcopolymere umfassen mindestens einen Block, der aus Alkenylaromaten gebildet wird, und einen Block, der aus 1,3-Alkadienen gebildet wird. Bei den Alkenylaromaten kann es sich beispielsweise um Styrol, $\alpha$-Methylstyrol oder Vinyltoluol handeln. Bevorzugt ist Styrol. Es können Blockcopolymere vom Styrol-Butadien-Typ (Mittelblock: Butadienphase) vom Styrol-Isopren-Typ (Mittelblock: Isoprenphase) oder vom Styrol-Butadien-Isopren-Typ (Mittelblock: Butadien-Isoprenphase) eingesetzt werden. Bei den Blockcopolymeren kann es sich sowohl um lineare, verzweigte oder radiale Blockcopolymere handeln. Im Allgemeinen handelt es sich um Dreiblockcopolymere vom A-B-A-Typ, es kann sich aber auch um Zweiblockpolymere vom A-B-Typ handeln, oder um solche mit mehreren alternierenden elastomeren und thermoplastischen Blöcken, z.B. A-B-A-B-A. Es können auch Gemische aus zwei oder mehr verschiedenen Blockcopolymere eingesetzt werden. Handelsübliche Dreiblockcopolymere enthalten häufig gewisse Anteile an Zweiblockcopolymeren. Die Dien-Einheiten können 1,2- oder 1,4-verknüpft sein. Weiterhin einsetzbar sind auch thermoplastisch elastomere Blockcopolymere mit Endblöcken aus Styrol und einem statistischen Styrol-Butadien-Mittelblock, die unter dem Namen Styroflex® erhältlich sind. Selbstverständlich können auch Gemische mehrerer thermoplastisch-elastomerer Bindemittel eingesetzt werden, vorausgesetzt, die Eigenschaften der reliefbildenden Schicht werden dadurch nicht negativ beeinflusst.

In einer bevorzugten Ausführungsform wird ein Bindemittel vom Styrol-Butadien-Typ eingesetzt. Besonders bevorzugte Bindemittel sind lineare, radiale oder verzweigte Blockcopolymere vom Styrol-Butadien-Typ. Diese Blockcopolymere haben ein mittleres Molekulargewicht $M_w$ (Gewichtsmittel) von 80 000 bis 250 000 g/mol, bevorzugt 80 000 bis 150 000 g/mol, und besonders bevorzugt von 90 000 bis 130 000 g/mol und weisen einen Styrolgehalt von 20 bis 40 Gew.-%, bevorzugt 20 bis 35 Gew.-% und besonders bevorzugt von 20 bis 30 Gew.-% auf.

In einer weiteren bevorzugten Ausführungsform der Erfindung handelt es sich um ein Bindemittel vom Styrol-Isopren-Typ. Bevorzugte Bindemittel vom Styrol-Isopren-Typ enthalten in der Regel 13 bis 40 Gew.-%, bevorzugt 13 bis 35 Gew.-% und besonders bevorzugt von 14 bis 30 Gew.-% Styrol.

Neben den genannten Blockcopolymeren kann die fotopolymerisierbare Schicht auch noch weitere, von den Blockcopolymeren verschiedene elastomere Bindemittel umfassen. Mit derartigen zusätzlichen Bindemitteln, auch sekundäre Bindemittel genannt, lassen sich die Eigenschaften der fotopolymerisierbaren Schicht modifizieren. Im Regelfalle soll die Menge derartiger sekundärer Bindemittel 25 Gew. %, bezogen auf die Gesamtmenge aller eingesetzten Bindemittel, nicht überschreiten. Bevorzugt übersteigt die Menge nicht 15 Gew. %, besonders bevorzugt nicht 10 Gew. % und ganz besonders bevorzugt sind ausschließlich die genannten Blockcopolymere aus Alkenylaromaten und 1,3-Dienen vorhanden.

Die Gesamtmenge an Bindemitteln beträgt dabei 40 bis 90 Gew.-%, bezogen auf die Summe aller Bestandteile der reliefbildenden Schicht, bevorzugt 45 bis 75 Gew.-% und besonders bevorzugt 50 bis 70 Gew.-%.

Die fotopolymerisierbare reliefbildende Schicht umfasst weiterhin mindestens ein ethylenisch ungesättigtes Monomer M. Die eingesetzten Monomere M sind mit den Bindemitteln verträglich und weisen mindestens eine polymerisierbare, ethylenisch ungesättigte Gruppe auf. Neben dem oder den ethylenisch ungesättigten Monomeren M1 können noch weitere ethylenisch ungesättigte Monomere M2 in der vorhanden sein.

Die Monomere M1 sind mit den Polyalkadienblöcken der Bindemittel kompatibel, im Falle von Dreiblockcopolymeren also mit dem Mittelblock. Geeignete Monomere M1 weisen die allgemeine Formel $E_n$-$R^n$ auf, wobei $R^n$ für einen n-wertigen Kohlenwasserstoffrest, E für eine ethylenisch ungesättigte Gruppe und n für eine natürliche Zahl von 1 bis 3, bevorzugt 1 oder 2 steht. Bei den ethylenisch ungesättigten Gruppen handelt es sich bevorzugt um Acrylat- oder Methacrylatgruppen. Erfindungsgemäß wird mindestens ein Monomer M1 eingesetzt, welches zwei (Meth)acrylatgruppen umfasst.

Erfindungsgemäß handelt es sich bei dem Kohlenwasserstoffrest $R^n$ um einen mindestens 6 Kohlenstoffatome aufweisenden alicyclischen, gesättigten oder ungesättigten Kohlenwasserstoffrest, der optional noch mit weiteren aliphatischen linearen oder verzweigten Kohlenwasserstoffgruppen substituiert sein kann. Der Begriff alicyclisch wird im Rahmen dieser Erfindung im üblichen Sinne verwendet, nämlich für gesättigte oder ungesättigte aliphatische Kohlenwasserstoffreste, welche cyclische Strukturelemente aufweisen. Es handelt sich also nicht um aromatische Kohlenwasserstoffreste. Es kann sich bei dem alicyclischen Rest um einen monocyclischen Rest oder auch um polycyclische Rest, insbesondere bi- oder tricyclischen Rest, handeln. Bevorzugt handelt es sich um gesättigte alicyclische Reste. Bevorzugte Reste umfassen als Strukturelement mindestens einen Fünfring- und/oder einen Sechsring.

Erfindungsgemäß wird mindestens ein Monomer M1 ausgewählt aus der Gruppe bestehend aus

Di(meth)acrylaten der allgemeinen Formel $H_2$=CR-C(O)O-$R^2$-O(O)C=CH$_2$, wobei R für H oder eine Methylgruppe steht, und es sich bei $R^2$ um einen zweiwertigen alicyclischen Kohlenwasserstoffrest mit 10 bis 20, bevorzugt 12 bis 20 Kohlenstoffatomen handelt, eingesetzt.

Beispiele geeigneter Monomere M1 sind Tricyclodecandimethanoldiacrylat und Tricyclodecandimethanoldimethacrylat.

Besonders bevorzugt handelt es sich bei dem Monomer M1 um Tricyclodecandimethanoldiacrylat.

Die erfindungsgemäß eingesetzten Monomere M1 scheinen sich aufgrund ihrer Kompatibilität mit den Polyalkadienphasen bevorzugt in den Polyalkadienphasen anzureichern und dementsprechend das Volumen der Polyalkadienphasen zu vergrößern. Dies scheint wirksam die Härte der Flexodruckformen zu vergrößern und gleichzeitig die Ausrichtung der Styrolphasen zu zylinderförmigen bzw. stäbchenförmigen Phasen zu unterdrücken.

Selbstverständlich können auch Gemische verschiedener Monomere M1 eingesetzt werden. Im Allgemeinen beträgt die Menge der Monomere M1 0,1 bis 20 Gew.%, bevorzugt 0,5 bis 18 Gew.%, besonders bevorzugt 2 bis 15 Gew.%, ganz besonders bevorzugt 4 bis 13 Gew.-% und beispielsweise 6 bis 13 Gew. %, bezogen auf die Summe aller Bestandteile der reliefbildenden Schicht.

Neben den erfindungsgemäß eingesetzten Monomeren M1 können auch noch weitere, von den Monomeren M1 verschiedene Comonomere M2 eingesetzt werden. Als Comomere M2 können insbesondere Ester oder Amide der Acrylsäure oder Methacrylsäure mit mono- oder polyfunktionellen Alkoholen, Aminen, Aminoalkoholen oder Hydroxyethern und -estern, Ester der Fumar- oder Maleinsäure und Allylverbindungen eingesetzt werden, bevorzugt sind Ester oder Amide der Acrylsäure oder Methacrylsäure. Bevorzugt sind 1,4-Butandioldiacrylat, 1,6-Hexandioldiacrylat, 1,6-Hexandioldimethacrylat, 1,9-Nonandioldiacrylat, Trimethylolpropantri(meth)acrylat, Dioctylfumarat und N-Dodecylmaleimid und besonders bevorzugt ist 1,6-Hexandioldiacrylat. Im Allgemeinen beträgt die Menge der Comonomere M2 0 bis 10 Gew.-%, bevorzugt 0 bis 8 Gew.-% und besonders bevorzugt 0 bis 6 Gew.-%, bezogen auf die Summe aller Bestandteile der reliefbildenden Schicht.

Sofern weitere Monomere M2 in der fotopolymerisierbaren reliefbildenden Schicht vorhanden sind, sollte das Gewichtsverhältnis der Monomere M1 : M2 mindestens 1:1, bevorzugt mindestens 1,5 : 1, besonders bevorzugt mindestens 2 :1 und ganz besonders bevorzugt mindestens 3:1 betragen. Bevorzugt beträgt es höchstens 10 : 1.

Die Gesamtmenge aller Monomere M1 und M2 in der Schicht beträgt 0,1 bis 20 Gew.-%, bevorzugt 0,5 bis 18 Gew.-%, besonders bevorzugt 2 bis 15 Gew.-%, ganz besonders bevorzugt 4 bis 18 Gew.-% und beispielsweise 8 bis 15 Gew. %, bezogen auf die Summe aller Bestandteile der reliefbildenden Schicht.

In einer bevorzugten Ausführungsform der Erfindung umfasst die fotopolymerisierbare, reliefbildende Schicht als Monomere M mindestens ein Monomer M1b sowie mindestens ein Monomer M2, wobei das Verhältnis M1 : M2 mindestens 3 : 1 und vorzugsweise höchstens 10 : 1 beträgt. Vorzugsweise ist M2 dabei ein zwei (Meth)acrylatgruppen aufweisendes Monomer.

In einer besonders bevorzugten Ausführungsform der Erfindung umfasst die fotopolymerisierbare, reliefbildende Schicht als Monomere M1 mindestens Tricyclodecandimethanoldiacrylat sowie ein weiteres Monomer M2 im Verhältnis von mindestens 3 : 1 und vorzugsweise höchstens 10 : 1, wobei die Gesamtmenge von Tricyclodecandimethanoldiacrylat und dem weiteren Monomer M2 bevorzugt 10 bis 15 Gew. % beträgt. Bevorzugt handelt es sich bei dieser Ausführungsform bei M2 um 1,6-Hexandioldiacrylat.

Die fotopolymerisierbare, reliefbildende, fotopolymerisierbare Schicht umfasst weiterhin mindestens einen Fotoinitiator oder ein Fotoinitiatorsystem. Beispiele für geeignete Initiatoren sind Benzoin oder Benzoinderivate, wie Methylbenzoin oder Benzoinether, Benzilderivate, wie Benzilketale, Acylarylphosphinoxide, Acylarylphosphinsäureester, Mehrkernchinone oder Benzophenone. Die Menge an Fotoinitiator in der reliefbildenden Schicht beträgt in der Regel 0,1 bis 5 Gew.-%, bevorzugt 0,5 bis 4 Gew.-% und besonders bevorzugt 1 bis 3 Gew.-%, bezogen auf die Menge aller Bestandteile der reliefbildenden Schicht.

Erfindungsgemäß umfasst die reliefbildende Schicht weiterhin einen Weichmacher. Es können auch Gemische verschiedener Weichmacher eingesetzt werden. Beispiele für geeignete Weichmacher umfassen modifizierte und unmodifizierte Naturöle und -harze, wie hochsiedende paraffinische, naphthenische oder aromatische Mineralöle, synthetische Oligomere oder Harze wie Oligostyrol, hochsiedende Ester, oligomere Styrol-Butadien-Copolymere, oligomere $\alpha$-Methylstyrol/p-Methylstyrol-Copolymere, flüssige Oligobutadiene, insbesondere solche mit einem Molekulargewicht zwischen 500 und 5000 g/mol, oder flüssige oligomere Acrylnitril-Butadien-Copolymere oder oligomere Ethylen-Propylen-Dien-Copolymere. Bevorzugt sind Polybutadienöle, hochsiedende aliphatische Ester und Mineralöle oder flüssiger Isopren-Kautschuk (liquid isoprene rubber). Vorzugsweise mit einem Molekulargewicht von 500 bis 5000 g/mol und einer Viskosität von 500 bis 200.000 mPas bei 25°C. Insbesondere als Weichmacher bevorzugt sind Polybutadienöle mit einem hohen Anteil an 1,2-Vinylgruppen, da diese, im Vergleich zu Polybutadienölen mit einem geringen 1,2-Vinylgruppengehalt, zu einer höheren Vernetzungsdicht und damit zu härteren Platten führen. Im Allgemeinen beträgt der Anteil an 1,2-Vinylgruppen, bezogen auf den Gesamtgehalt an Vinylgruppen, > 10%, bevorzugt > 25%, besonders bevorzugt > 40%. Im Allgemeinen beträgt der Weichmachergehalt 1 bis 40 Gew.-%, bevorzugt 10 bis 35 Gew.-%, besonders bevorzugt 15 bis 30 Gew.-%.

Die fotopolymerisierbare reliefbildende Schicht kann weiterhin typische Additive und Zusatzstoffe enthalten. Beispiele für derartige Zusatzstoffe und Additive sind Farbstoffe, Inhibitoren für die thermische Polymerisation, Füllstoffe und Antioxidantien. Die Menge derartiger Zusatzstoffe sollte aber im Regelfalle 10 Gew.- % bezogen auf die Menge aller Komponenten der reliefbildenden Schicht, bevorzugt 5 Gew. % nicht überschreiten.

Die Rohschichtplastizität der fotopolymerisierbaren reliefbildenden Schicht (vor der Fotopolymerisation / Entwicklung) beträgt im Allgemeinen 5 bis 16, bevorzugt 8 bis 15. Die Rohschichtplastizität ist dabei die Differenz zwischen der Ausgangsschichtdicke der fotopolymerisierbaren reliefbildenden Schicht und der Schichtdicke nach einer einminütigen Belastung mit einem 50 g-Gewicht, wobei die Differenz in % des Ausgangswertes angegeben wird.

Der Schmelzflussindex (MVR) der fotopolymerisierbaren, reliefbildenden Schicht (vor der Fotopolymerisation / Entwicklung) beträgt im Allgemeinen 5 bis 50 cm$^3$ / 10 min, bevorzugt 8 bis 50 cm$^3$ / 10 min. Der Schmelzflussindex (MVR) wird dabei bei einer Temperatur von 100°C und einem Auflagegewicht von 5 kg wie in DIN ISO 1133 beschrieben bestimmt.

Aufgrund der Verwendung der besonderen Monomere beträgt die Härte der Reliefschicht der Flexodruckformen, d.h. der aus den fotopolymerisierbaren Schichten durch Polymerisation erhaltenen, fotopolymerisierten Reliefschichten, erfindungsgemäß mindestens 66° Shore A nach DIN 53505. Die Messmethode ist im Einzelnen im experimentellen Teil beschrieben. Im Allgemeinen beträgt die Shore A-Härte der fotopolymerisierten Schicht 66 bis 90° Shore A, bevorzugt 66 bis 85° Shore A und besonders bevorzugt 68 bis 85° Shore A.

Im Allgemeinen beträgt der Anisotropiefaktor der Reliefschicht der Flexodruckformen weniger als 1,2, bevorzugt weniger als 1,1. Dabei ist der Anisotropiefaktor AF wie folgt definiert:

$$AF = \sigma_{MD}(125\%) / \sigma_{TD}(125\%) \text{ wenn } \sigma_{MD}(125\%) > \sigma_{TD}(125\%)$$

$$AF = \sigma_{TD}(125\%) / \sigma_{MD}(125\%) \text{ wenn } \sigma_{TD}(125\%) > \sigma_{MD}(125\%)$$

wobei
$\sigma_{MD}(125\%)$ die Zugdehnungsspannung in Extrusionsrichtung bei 125% Dehnung, und
$\sigma_{TD}(125\%)$ die Zugdehnungsspannung quer zur Extrusionsrichtung bei 125% Dehnung ist.

Auf der gegebenenfalls mit der Entklebungsschicht beschichteten Trägerfolie kann sich optional eine elastomere Trägerschicht befinden. Die elastomere Trägerschicht weist unter Verarbeitungsbedingungen Schmelzbarkeit und Fließfähigkeit auf und weist eine ausreichend hohe Haftung zu der auf dem Hohlzylinder aufgebrachten Haftschicht bzw. zu dem Klebeband auf, auch nach Belichtung oder Rückseitenvorbelichtung. Die Trägerschicht kann optional fotochemisch vernetzbar sein.

Die elastomere Trägerschicht kann die fehlende Trägerfolie im Hinblick auf deren mechanischen Eigenschaften ersetzen. So kommt es trotz der fehlenden starren Trägerfolie nicht zu einer Bildung von Anlaufkanten im Druck. Sie ist jedoch - im Gegensatz zu einer Trägerfolie - unter den Verarbeitungsbedingungen schmelzbar und fließfähig. Auch kann die Trägerschicht eine höhere Haftung zu der auf den Hohlzylinder aufgebrachten Haftschicht auf als die fotopolymerisierbare reliefbildende Schicht aufweisen. Der Tapespalt wird aufgrund der Härte und Steifheit der Trägerschicht überbrückt. Auf der elastomeren Trägerschicht befindet sich die fotopolymerisierbare reliefbildende Schicht.

Wie die fotopolymerisierbare reliefbildende Schicht enthält auch die elastomere Trägerschicht mindestens ein elastomeres Bindemittel.

Ganz besonders bevorzugt in der elastomeren Trägerschicht enthaltene elastomere Bindemittel sind Dreiblockcopolymere vom Typ A-B-A, radiale Blockcopolymeren vom Typ $(AB)_n$, worin A Styrol und B ein Dien sind, sowie statistische Copolymere und Random-Copolymere aus Styrol und einem Dien. Im Falle der elastomeren Trägerschicht kann die Gesamtmenge an elastomeren Bindemitteln bis zu 100 Gew.-% betragen. Üblicherweise beträgt sie 75 bis 100 Gew.-%, bevorzugt 85 bis 100 Gew.-% und besonders bevorzugt 90 bis 100 Gew.-%.

Die erfindungsgemäßen fotopolymerisierbaren Flexodruckelemente lassen sich nach dem Fachmann prinzipiell bekannten Methoden herstellen, beispielsweise durch Schmelzextrusion, Gießen oder Laminieren in einem einstufigen oder mehrstufigen Produktionsprozess. Bevorzugt ist die Herstellung mittels Schmelzextrusion, bei dem man zunächst die Bestandteile der reliefbildenden Schicht in einem Extruder unter Erwärmen miteinander mischt. Zur Herstellung von flächenförmigen Flexodruckelementen kann die fotopolymeriserbare Masse aus dem Extruder durch eine Breitschlitzdüse zwischen zwei Folien ausgetragen und der Schichtenverbund kalandriert werden, wobei sich die Art der Folien nach dem gewünschten Verwendungszweck richtet. Es kann sich hierbei um Folien handeln, welche eine gute Haftung mit der fotopolymerisierbaren Schicht aufweisen oder um leicht abziehbare (temporäre) Folien. Zur Herstellung von flächenförmigen Flexodruckelementen wird üblicherweise eine gut haftende Trägerfolie und eine abziehbare Deckfolie eingesetzt. Ist die Weiterverarbeitung der Schicht zu zylindrischen Flexodruckelementen nach dem nachstehend beschriebenen Verfahren vorgesehen, dann werden zwei abziehbare Folien verwendet. Zur Herstellung von fotopolymerisierbaren, zylindrischen Flexodruckelementen kann auch eine nahtlose Schicht mittels Ringextrusion direkt auf einen zylindrischen Träger aufgebracht werden. Die Dicke der fotopolymerisierbaren Schicht beträgt im Allgemeinen 0,4 bis 7 mm, bevorzugt 0,5 bis 4 mm und besonders bevorzugt 0,7 bis 2,5 mm.

Die Herstellung von zylindrischen endlos-nahtlosen Flexodruckelementen und deren Weiterverarbeitung zu endlos-nahtlosen Druckformen kann in Anlehnung an das von WO 2004/092841 beschriebene Verfahren erfolgen.

Dementsprechend wird ein zylindrisches, endlos-nahtlosen fotopolymerisierbaren Flexodruckelements hergestellt durch

a) Bereitstellen eines Schichtenverbundes umfassend eine abziehbare temporäre Trägerfolie, gegebenenfalls eine elastomere Trägerschicht, eine fotopolymerisierbare, reliefbildende Schicht wie in einem der Ansprüche 1 bis 11 definiert, und eine abziehbare temporäre Deckfolie,
b) Zurechtschneiden der zu verbindenden Kanten des Schichtenverbundes,
c) Aufschieben und Arretieren eines Hohlzylinders auf einen drehbar gelagerten Trägerzylinder,
d) Aufbringen einer Haftschicht auf die äußere Fläche des Hohlzylinders,
e) Aufbringen des zurechtgeschnittenen Schichtenverbundes aus der fotopolymerisierbaren reliefbildenden Schicht, gegebenenfalls der elastomeren Trägerschicht und der abziehbaren Deckfolie nach Abziehen der temporären Trägerfolie mit der fotopolymerisierbaren reliefbildenden Schicht bzw. der elastomeren Trägerschicht auf den mit der Haftschicht versehenen Hohlzylinder,
f) Abziehen der Deckfolie von der Schicht aus fotopolymerisierbarem Material,
g) Verbinden der Schnittkanten bei einer Temperatur unterhalb der Schmelztemperatur der fotopolymerisierbaren Schicht, indem man die Oberfläche der fotopolymerisierbaren Schicht auf dem Hohlzylinder mit einer sich drehenden Kalanderwalze in Kontakt bringt, bis die Schnittkanten miteinander verbunden sind,
h) Abziehen des bearbeiteten Hohlzylinders vom Trägerzylinder.

Zylindrische Flexodruchelemetne können aber auch mittels anderer Techniken hergestellt werden.

Für das Verfahren gemäß WO 2004/092841 wird als Ausgangsmaterial eine vorgefertigte Schicht aus fotopolymerisierbarem Material hergestellt. Die fotopolymerisierbare Schicht kann optional vor dem Aufbringen auf den Hohlzylinder mit aktinischem Licht von der Rückseite her vorbelichtet werden. Die Vorbelichtung sollte im Regelfalle vor dem Zurechtschneiden des Schichtenverbundes in Schritt (b) erfolgen, um eine homogene, gleichmäßige Vorbelichtung auch in den Randbereichen zu gewährleisten. Falls eine UV-transparente Hülse eingesetzt wird, kann die Vorbelichtung auch erst nach dem Aufbringen der Schicht auf die Hülse von der Innenseite der Hülse aus erfolgen. Anschließend werden die zu verbindenden Kanten des bereitgestellten Schichtenverbundes zurechtgeschnitten.

Bevorzugt erfolgt das Zurechtschneiden der zu verbindenden Kanten mittels Gehrungsschnitten.

Bei den als Träger verwendeten Hohlzylindern handelt es sich um übliche Hohlzylinder, die zur Montage auf Luftzylinder geeignet sind, d.h. sich unter dem Einfluss von Druckluft geringfügig dehnen können. Derartige Hohlzylinder werden auch als Hülsen oder manchmal auch als Sleeves, Basis-Sleeves oder dergleichen bezeichnet.

Anschließend werden die verwendeten Hohlzylinder auf einen drehbar gelagerten Trägerzylinder aufgeschoben und arretiert, so dass der Hohlzylinder mit dem Trägerzylinder fest verbunden ist. Der Trägerzylinder bietet dem Holzzylinder einen festen Halt für den nachfolgenden Kalandrierprozess.

Danach wird die Haftschicht auf die äußere Fläche des Hohlzylinders aufgebracht. Die Haftschicht soll auch noch bei erhöhten Temperaturen, wie sie während des Kalandriervorganges herrschen, eine gute Haftung vermitteln. Sie soll insbesondere eine sehr gute Scherfestigkeit vermitteln, damit die fotopolymerisierbare Schicht während des Kalandriervorganges nicht auf der Oberfläche des Hohlzylinders verrutscht. Bei der Haftschicht kann es sich um einen geeigneten Haftlack handeln, der auf die Oberfläche des Hohlzylinders aufgetragen wird. Bevorzugt handelt es sich aber bei der Haftschicht um eine doppelseitige Klebefolie. Insbesondere kann es sich bei den Klebefolien um Schaumklebefolien handeln, welche zusätzlich eine dämpfende Schaumstoffschicht aufweisen.

Anschließend erfolgt das Aufbringen der fotopolymerisierbaren Schicht auf den mit der Haftschicht versehenen Hohlzylinder. Sind die zu verbindenden Kanten des Schichtverbundes mittels Gehrungsschnitten zurechtgeschnitten worden, so liegen die mit dem Gehrungsschnitt versehenen Enden im Wesentlichen aufeinander, ohne dabei zu überlappen. Nach dem Aufbringen der Schicht wird die temporäre Deckfolie inklusive einer eventuell vorhandenen Entklebeschicht von der Schicht aus fotopolymerem Material abgezogen.

Danach werden die Schnittkanten verbunden. Zum Verbinden der Schnittkanten wird die Oberfläche der fotopolymerisierbaren Schicht auf dem Hohlzylinder mit einer sich drehenden Kalanderwalze in Kontakt gebracht, bis die Schnittkanten miteinander verbunden sind. Der Trägerzylinder und die Kalanderwalze drehen sich gegeneinander. Der notwendige Kalanderdruck wird vom Fachmann je nach der Art der fotopolymerisierbaren Schicht durch das Einstellen des Abstandes zwischen dem Trägerzylinder und der Kalanderwalze bestimmt. Die Kalandriertemperatur richtet sich nach der Art der fotopolymerisierbaren Schicht und den gewünschten Eigenschaften. Die Temperatur der Kalanderwalze wird aber erfindungsgemäß so eingestellt, dass die Temperatur der fotopolymerisierbaren Schicht in jedem Falle unterhalb deren Schmelztemperatur liegt. Zweckmäßigerweise erfolgt die Wärmezufuhr, indem man eine von Innen beheizte Kalanderwalze, einen IR-Strahler oder warme Gasströme einsetzt. Selbstverständlich können Wärmequellen auch kombiniert werden. Im Regelfalle beträgt die Temperatur beim Kalandrieren 80 bis 140°C, bevorzugt 90 bis 130°C, jeweils gemessen an der Oberfläche der fotopolymerisierbaren Schicht. Im Regelfalle sind bis zu einem vollständigen Spaltverschluss ca. 15 min erforderlich, wobei diese Zeit natürlich auch von der gewählten Temperatur und dem Druck abhängt.

Nach dem Verschließen der Naht und gegebenenfalls Abkühlen wird der bearbeitete Hohlzylinder / fertige Sleeve wieder vom Trägerzylinder abgenommen.

Die Weiterverarbeitung der fotopolymerisierbaren Flexodruckelemente zu fertigen Flexodruckformen kann nach verschiedenen Techniken erfolgen. Die Flexodruckelemente können beispielsweise auf prinzipiell bekannte Art und Weise bildmäßig belichtet und die unbelichteten Bereiche der reliefbildenden Schicht anschließend mittels eines geeigneten Entwicklungsprozesses entfernt werden. Die bildmäßige Belichtung kann grundsätzlich durch Bedecken der fotopolymerisierbaren Flexodruckelemente mit einer fotografischen Maske und Belichten durch die Maske hindurch erfolgen.

Bevorzugt wird die Bebilderung aber mittels digitaler Masken vorgenommen. Derartige Masken sind auch als In-situ-Masken bekannt. Hierzu wird zunächst eine digital bebilderbare Schicht auf die fotopolymerisierbare, reliefbildende Schicht aufgebracht. Bevorzugt handelt es sich bei der digital bebilderbaren Schicht um eine IR-ablative Schicht, Ink-Jet-Schicht oder thermografisch beschreibbare Schicht.

IR-ablative Schichten bzw. Masken sind für die Wellenlänge des aktinischen Lichtes opak und umfassen üblicherweise ein Bindemittel sowie mindestens einen IR-Absorber wie beispielsweise Ruß. Ruß sorgt auch dafür, dass die Schicht opak ist. In die IR-ablative Schicht kann mittels eines IR-Lasers eine Maske eingeschrieben werden, d.h. die Schicht wird an den Stellen, an denen sie vom Laserstrahl getroffen wird, zersetzt und abgetragen. Beispiele für die Bebilderung von Flexodruckelementen mit IRablativen Masken sind beispielsweise in EP-A 654 150 oder EP-A 1 069 475 offenbart.

Bei Ink-Jet-Schichten wird eine mit Ink-Jet-Tinten beschreibbare, für aktinisches Licht durchlässige Schicht, beispielsweise eine Gelatine-Schicht aufgetragen. Auf diese wird mittels Ink-Jet-Druckern eine Maske mit opaker Tinte aufgetragen. Beispiele sind in EP-A 1 072 953 offenbart.

Bei thermografischen Schichten handelt es sich um Schichten, die Substanzen enthalten, die sich unter dem Einfluss von Hitze schwarz färben. Derartige Schichten umfassen beispielsweise ein Bindemittel und ein organisches Silbersalz und können mittels eines Druckers mit Thermokopf bebildert werden. Beispiele sind in EP-A 1 070 989 offenbart.

Die digital bebilderbaren Schichten können durch Lösen bzw. Dispergieren aller Bestandteile der jeweiligen Schicht in einem geeigneten Lösemittel und Aufbringen der Lösung auf die fotopolymerisierbare Schicht des zylindrischen Flexodruckelementes, gefolgt vom Verdampfen des Lösemittels hergestellt werden. Das Aufbringen der digital bebilderbaren Schicht kann beispielsweise durch Aufsprühen oder mittels der von EP-A 1 158 365 beschriebenen Technik erfolgen.

Nach dem Aufbringen der digital bebilderbaren Schicht wird diese mittels der jeweils geeigneten Technik bebildert und anschließend die fotopolymerisierbare Schicht durch die gebildete Maske hindurch in prinzipiell bekannter Art und Weise mittels aktinischen Lichts bestrahlt. Als aktinisches, also chemisch "wirksames" Licht eignet sich insbesondere UVA- bzw. UV/VIS-Strahlung. Belichter für plattenförmige Flexodruckelemente sowie Rundbelichter zur gleichmäßigen Belichtung von zylindrischen Flexodruckelementen sind kommerziell erhältlich.

Das Entwickeln der bildmäßig belichteten Schicht kann auf konventionelle Art und Weise mittels eines Lösemittels oder eines Lösemittelgemisches erfolgen. Dabei werden die nicht belichteten, d.h. die von der Maske abgedeckten Bereiche der Reliefschicht durch Auflösen im Entwickler entfernt, während die belichteten, also vernetzten Bereiche erhalten bleiben. Die Maske oder die Reste der Maske werden ebenfalls vom Entwickler entfernt, falls die Komponenten darin löslich sind. Falls die Maske nicht im Entwickler löslich ist, wird sie gegebenenfalls vor dem Entwickeln mit Hilfe eines zweiten Lösemittels entfernt.

Die Entwicklung kann auch thermisch erfolgen. Bei der thermischen Entwicklung wird kein Lösemittel eingesetzt. Stattdessen wird die reliefbildende Schicht nach der bildmäßigen Belichtung mit einem absorbierenden Material in Kontakt gebracht und erwärmt. Bei dem absorbierenden Material handelt es sich beispielsweise um ein poröses Vlies, beispielsweise aus Nylon, Polyester, Cellulose oder anorganischen Materialien. Es wird auf eine solche Temperatur erwärmt, dass sich die nicht polymerisierten Anteile der reliefbildenden Schicht verflüssigen und vom Vlies aufgesogen werden können. Das voll gesogene Vlies wird anschließend entfernt. Einzelheiten zur thermischen Entwicklung sind beispielsweise von US 3,264,103, US 5,175,072, WO 96/14603 oder WO 01/88615 offenbart. Die Maske kann gegebenenfalls vorher mittels eines geeigneten Lösemittels oder ebenfalls thermisch entfernt werden.

Die Reliefschicht der druckfertigen Flexodruckformen, d.h. der fotopolymerisierten Schicht, weist erfindungsgemäß eine Härte von mindestens 66° Shore A nach DIN 53505 auf . Im Allgemeinen beträgt die Shore A-Härte der fotopolymerisierten Schicht 66 bis 90° Shore A, bevorzugt von 66 bis 85° Shore A und ganz besonders bevorzugt 68 bis 85° Shore A.

Die Herstellung von Flexodruckformen aus den fotopolymerisierbaren Flexodruckelementen kann auch mittels Laser-Direktgravur vorgenommen werden. Bei diesem Verfahren wird die fotopolymerisierbare Schicht zunächst ohne Auflegen einer Maske vollständig im gesamten Volumen mit aktinischem Licht, Elektronenstrahlen oder $\gamma$-Strahlen vernetzt. Anschließend wird in die vernetzte Schicht mit einem oder mehreren Lasern ein Druckrelief eingraviert.

Die vollflächige Vernetzung kann mit üblichen Belichtern für Flexodruckformen wie oben.beschrieben erfolgen. Besonders vorteilhaft kann sie aber-insbesondere bei zylindrischen, endlos-nahtlosen Flexodruckformen- auch in Anlehnung an das in WO 01/39897 beschriebene Verfahren erfolgen. Hierbei wird in Anwesenheit eines Schutzgases, welches schwerer ist als Luft, beispielsweise $CO_2$ oder Ar, belichtet. Das fotopolymerisierbare, zylindrische Flexodruckelement wird hierzu in ein mit Schutzgas gefülltes Tauchbecken abgesenkt, dessen Wände bevorzugt mit einem reflektierenden Material, beispielsweise Aluminium-Folie, ausgekleidet sind. Anschließend wird mit aktinischem Licht belichtet. Es können hierzu im Prinzip die üblichen UV- bzw. UV/VIS-Quellen für aktinisches Licht verwendet werden. Bevorzugt werden Strahlungsquellen eingesetzt, welche im Wesentlichen sichtbares Licht und keine oder nur geringe Anteile von UV-Licht emittieren. Bevorzugt sind Lichtquellen, die Licht mit einer Wellenlänge von mehr als 300 nm emittieren. Beispielsweise können übliche Halogenlampen oder UVA-Röhren verwendet werden.

Bei der Laser-Direktgravur absorbiert die Reliefschicht Laserstrahlung in einem solchen Ausmaß, dass sie an den Stellen, an denen sie einem Laserstrahl ausreichender Intensität ausgesetzt ist, entfernt oder zumindest abgelöst wird. Vorzugsweise wird die Schicht dabei ohne vorher zu schmelzen verdampft oder thermisch oder oxidativ zersetzt, so dass ihre Zersetzungsprodukte in Form von heißen Gasen, Dämpfen, Rauch oder kleinen Partikeln von der Schicht entfernt werden.

Zur Gravur der erfindungsgemäß eingesetzten reliefbildenden Schichten eignen sich insbesondere Laser, die eine Wellenlänge von 9000 nm bis 12 000 nm aufweisen. Zu nennen sind hier insbesondere $CO_2$-Laser. Die in der reliefbildenden Schicht verwendeten Bindemittel absorbieren die Strahlung derartiger Laser in ausreichendem Maße, um graviert werden zu können.

Vorteilhaft kann die erhaltene Flexodruckform im Anschluss an die Lasergravur in einem weiteren Verfahrensschritt nachgereinigt werden. In manchen Fällen kann dies durch einfaches Abblasen mit Druckluft oder Abbürsten geschehen. Es ist aber bevorzugt, zum Nachreinigen ein flüssiges Reinigungsmittel einzusetzen, um auch Polymerbruchstücke vollständig entfernen zu können. Geeignet sind beispielsweise wässrige Reinigungsmittel, welche im Wesentlichen aus Wasser sowie optional geringen Mengen von Alkoholen bestehen, und die zur Unterstützung des Reinigungsvorganges Hilfsmittel, wie beispielsweise Tenside, Emulgatoren, Dispergierhilfsmittel oder Basen enthalten können. Geeignet sind auch "Wasser-in-Öl"-Emulsionen, wie von EP-A 463 016 offenbart. Bevorzugt werden Reinigungsmittel eingesetzt, welche mindestens eine organische Komponente aufweisen, die in der Lage ist, die im Zuge der Lasergravur auf dem Relief des Flexodruckelementes abgelagerten Zersetzungsprodukte abzulösen, ohne dass die Reliefschicht während des Reinigungsvorganges wesentlich gequollen wird. Derartige Reinigungsmittel sind beispielsweise in WO 2005/113240 offenbart.

Durch die erfindungsgemäße Verwendung der Monomere M1 lassen sich härtere, aber dennoch anisotropiefreie Flexodruckformen erhalten. Weitere Einzelheiten zu den Eigenschaften sind in den nachfolgenden Beispielen dargestellt.

Überraschenderweise nimmt darüber hinaus auch noch die Quellbeständigkeit der Flexodruckformen zu. Eine gute Quellbeständigkeit ist für qualitativ hochwertiges Drucken wichtig, damit die Flexodruckform nicht im Laufe des Druckvorganges von den in den Druckfarben enthaltenen Lösemitteln zu stark aufgequollen wird. Das Aufquellen der Druckform führt mit zunehmender Auflage zu abnehmender Härte der Druckform und zu einer unerwünschten Veränderung des Druckbildes: Die einzelner Bildelemente einer Druckform, insbesondere einzelne Rasterpunkte, verbreitern sich, und somit nimmt die Tonwertübertragung zu. Die erfindungsgemäßen Flexodruckelemente führen zu Flexodruckformen mit verringerter Quellbarkeit, also höherer Quellbeständigkeit.

Die Erfindung wird durch die nachstehenden Beispiele näher erläutert.

**Beispiele**

In den Beispielen und Vergleichsbeispielen werden verschiedene zylindrische endlos-nahtlose Flexodruckelemente hergestellt, deren fotopolymerisierbare Schicht jeweils eine unterschiedliche Zusammensetzung aufweist. Anschließend werden die Flexodruckelemente zu zylindrischen endlos-nahtlosen Druckformen verarbeitet und untersucht.

1) Allgemeine Vorschrift zur Herstellung der eingesetzten fotopolymerisierbaren reliefbildenden Schicht:

In den nachfolgenden Beispielen wird die fotopolymerisierbare Masse jeweils extrudiert, durch eine Breitschlitzdüse ausgetragen und zwischen

(1) ein Trägerelement, bestehend aus einer abziehbaren, mit einer 5 $\mu$m dicken Schicht aus einem elastomeren Polyamid (Makromelt® 6900) als Entklebeschicht beschichteten PET-Trägerfolie und einer zusätzlichen, 125 $\mu$m dicken Trägerschicht aus 94 Gew.-% Styrol, 5 Gew.-% Hexandioldimethacrylat und 1 % Benzildimethylketal einerseits, und

(2) eine mit einer Entklebeschicht aus Makromelt® 6900 beschichteten PET-Folie als abziehbare Deckfolie andererseits kalandriert.

Der Verbund aus Trägerschicht und photopolymerer Schicht hatte eine Gesamtdicke von 1,14 mm, exklusive der PET-Folien.

2) Allgemeine Vorschrift zur Herstellung der nahtlos-endlosen fotopolymerisierbaren Flexodruckelemente:

Zur Herstellung einer nahtlos/endlosen Druckform wird zunächst die zu belegende Hülse auf den Luftzylinder des Montagegeräts aufgeschoben. Dann wird eine Klebefolie auf dem Montagetisch zurechtgeschnitten, der Luftzylinder in Drehung versetzt und die Folie langsam bis in den Spalt zwischen Hilfswalze und dem mit der Hülse versehenen Luftzylinder eingeschoben. Durch die Drehung wird die Klebefolie mitgenommen, wobei die Hilfswalze die Folie gleichmäßig auf die Hülse drückt, so dass die Klebefolie blasenfrei an der Hülse festklebt. Danach wird die Schutzfolie von der Klebfolie abgezogen. Die Hülse ist nun mit einer Haftschicht versehen. Im nächsten Schritt wird das zurechtgeschnittene fotopolymerisierbare Material nach Entfernung der Trägerfolie in den Spalt eingeschoben, mitgenommen und von der Hilfswalze festgedrückt. Eine sich ggf. auf dem fotopolymerisierbaren Material befindliche Trägerschicht verbleibt dabei auf dem fotopolymerisierbaren Material und ist zur Hülse hin gerichtet. Nach der Montage des photopolymeren Materials wird die belegte Hülse auf den Luftzylinder der Kalandriereinheit geschoben. Nach dem Abziehen der Deckfolie werden dann die Kalanderwalze und der mit Hülse, Haftschicht und fotopolymerisierbarer Schicht versehene Luftzylinder in Kontakt miteinander gebracht, in Drehung versetzt, und der Spalt durch Kalandrieren unter Druckund Wärmeeinwirkung verschlossen.

3) Allgemeine Vorschrift zur Weiterverarbeitung der nahtlos-endlosen fotopolymerisierbaren Flexodruckelemente zu den fertigen nahtlos/endlosen Druckformen:

Die im vorherigen Schritt hergestellten nahtlos/endlosen Druckformen werden unter Einsatz eines Ringcoaters mit einer digital bebilderbaren Schicht (DSL II 80 Lösung, Flint Group Printing Plates) beschichtet und mit einem Laser (ESKO CDI COMPAKT) bebildert. Die bebilderte Druckform wird dann in einem Rundbelichter (Flint Group Printing Plates) belichtet, in einem Rundwascher (Flint Group Printing Plates) mittels eines Auswaschmittels (nylosolv® A, Flint Group Printing Plates) ausgewaschen, in einem Trockner (Flint Group Printing Plates) bei 45°C eine Stunde lang getrocknet und anschließend im Rundbelichter nachbelichtet.

4) Verwendete Einsatzstoffe:

Kraton® D-1102:    SBS-Blockcopolymer mit (Kraton Polymers) einem Styrolanteil von 29,5 Gew.-% und einer Härte von 70° Shore A (Diblockanteil 17%);

Kraton® D-1192:    SBS-Blockcopolymer (Kraton Polymers) mit einem Styrolgehalt von 30 Gew.-% und einer Härte von 70° Shore A (Diblockanteil < 1 %);

Kraton® D-1101:    SBS-Blockcopolymer (Kraton Polymers) mit einem Styrolanteil von 31 Gew.% und einer Härte von 72° Shore A (Diblockanteil 16 %);

Polyöl® 130:    Polybutadienöl (Degussa) mit einem Molgewicht von ca. 3000 g/mol, einer Viskosität von 2700 - 3300 mPas bei 20 °C und einem Anteil an 1,2-Vinylgruppen von ca. 1%;

Nisso® PB B-1000    Polybutadienöl (Nippon Soda) mit einem Molgewicht von 900 - 1300 g/mol, einem Anteil an 1,2-Vinylgruppen von > 85% und einer Viskosität von 5 - 15 Poise bei 45°C.

Laromer® HDDA:    1,6-Hexandioldiacrylat (BASF);

Sartomer® 833S:    Tricyclodecandimethanoldiacrylat (Sartomer).

5) Bestimmung der Messwerte

5.1) Bestimmung des Schmelzflussindex:

Der Schmelzflussindex (MVR) der unbelichteten fotopolymerisierbaren Schicht wurde bei einer Temperatur von 100°C und einem Auflagegewicht von 5 kg wie in DIN ISO 1133 beschrieben bestimmt.

5.2) Bestimmung der Shore Härte:

Die Messung der Shore A Härte erfolgte nach DIN 53 505. Hierfür wurden Schichten entsprechend den Beispielen in einer Dicke von 1 mm hergestellt und durch 15-minütiges vollflächiges Belichten mit UVA-Licht (Belichter F III, Flint Group Germany GmbH) vernetzt. Von jedem Schichttyp wurden jeweils 6 Stück 1 mm dicke Schichten übereinander gestapelt, um eine Gesamtschichtdicke von 6 mm zu erzielen. Von den 6 mm dicken Schichtstapeln wurde die Härte mit einem Härtemessgerät (Typ U72 / 80E, Heinrich Bareiss Prüfgerätebau GmbH) nach DIN 53 505 ermittelt.

5.3) Bestimmung der Rohschichtplastizität:

Zur Bestimmung der Rohschichtplastizität wurde ein Stück einer unbelichteten Platte 1 Minute mit einem 50 g-Gewicht (Durchmesser 4 mm) belastet. Die Rohschichtplastizität ist dabei die Differenz zwischen der Ausgangsschichtdicke und der Schichtdicke nach einer einminütigen Belastung mit einem 50 g-Gewicht, wobei die Differenz in % des Ausgangswertes angegeben wird.

5.4) Bestimmung des Anisotropiefaktors:

Die für die Berechnung des Anisotropiefaktors AF gemäß AF = $\sigma_{MD}(125\%)$ / $\sigma_{TD}(125\%)$ wenn $\sigma_{MD}(125\%)$ > $\sigma_{TD}(125\%)$ und AF = $\sigma_{TD}(125\%)$ / $\sigma_{MD}(125\%)$ wenn $\sigma_{TD}(125\%)$ > $\sigma_{MD}(125\%)$ erforderlichen Zugdehnungsspannungen $\sigma_{MD}(125\%)$ = in Extrusionsrichtung bei 125 % Dehnung und $\sigma_{TD}(125\%)$ = quer zur Extrusionsrichtung bei 125 % Dehnung wurden mit einem Zugdehnungsmessgerät vom Typ Zwick Z2.5/TN1S (Zwick GmbH & Co. KG) bestimmt.
Das Flexodruckelement gilt für die Praxis als im Wesentlichen isotrop, wenn der Anisotropiefaktor die Bedingung AF ≤ 1,2 erfüllt.
Gemäß der allgemeinen Vorschrift wurden die nachfolgend beschriebenen fotopolymerisierbaren Flexodruckelemente hergestellt und jeweils zu Flexodruckformen weiterverarbeitet. Die Zusammensetzung der Schicht sowie die erhaltenen Messwerte sind in den Tabellen 1 und 2 zusammengestellt.

**Vergleichsbeispiel V1:**

Herstellung einer typische harten Flexodruckform für den hochqualitativen Rasterdruck:
Ein Flexodruckelement wurde in einer Stärke von 1.14 mm exklusive PET-Folien, wie in der allgemeinen Vorschrift beschrieben, hergestellt. Die Härte der hergestellten Platte betrug nach DIN 62° Shore A. Der Anisotropiefaktor betrug 1, die Rohschichtplastizität 10,7 %.

**Vergleichsbeispiele V2 und V3:**

In den Vergleichsbeispielen V2 und V3 wurde ausgehend von Vergleichsbeispiel V1 versucht, die Härte des Flexodruckelementes durch Variation des Bindemittels zu erreichen. Verwendet wurden mit Kraton D-1192 (Styrolanteil: 30%) bzw. Kraton D-1101 (Stryolanteil: 31%) zwei Kautschuke mit einem, verglichen mit Kraton D-1102 (Stryolanteil: 29,5%), höheren Styrolanteil.

**Vergleichsbeispiele V4 bis V6:**

In den Vergleichsbeispielen V4 bis V6 wurde versucht, die Härte der reliefbildenden Schicht durch Variation des Monomergehalts zu erreichen. Ausgehend von Vergleichsbeispiel V1 wurde der Monomergehalt dabei schrittweise von 8% auf 15% erhöht.

**Vergleichsbeispiele V7 bis V10:**

In den Vergleichsbeispielen V7 bis V10 wurde ausgehend von Vergleichsbeispiel V4 versucht, die Härte des Flexodruckelementes durch eine Reduktion des Weichmacheranteils (Vergleichsbeispiele V7 und V8) bzw. durch den Einsatz eines hoch vinylgruppenhaltigen Weichmachers zu erhöhen.

**Beispiele 1 bis 4**

In den Beispielen 1 bis 4 wurde neben HDDA als Monomer (in allen Fällen 2 Gew.-%) mit Sartomer 833 S (Tricyclodecandimethanoldiacrylat) ein zweites Monomer in einer Menge von 8 Gew.-% bzw. 13 Gew.-% eingesetzt.

Tabelle 1: Rezeptur der fotopolymerisierbaren Schicht der Vergleichsbeispiele V1 bis V10 (Angaben in Gew.-%) sowie erhaltene Messwerte: Schmelzflussindex und Rohschichtplastizität des fotopolymerisierbaren Flexodruckelementes; Härte und Anisotropiefaktor der fertigen Flexodruckform

| | Komponente | V1 | V2 | V3 | V4 | V5 | V6 | V7 | V8 | V9 | V10 |
|---|---|---|---|---|---|---|---|---|---|---|---|
| **Bindemittel** | Kraton D-1102 | 59% | | | 57% | 54,5% | 52% | 62% | 67% | 57% | 62% |
| | Kraton D-1192 | | 59% | | | | | | | | |
| | Kraton D-1101 | | | 59% | | | | | | | |
| **Monomer** | Hexandioldiacrylat | 8% | 8% | 8% | 10% | 12,5% | 15% | 10% | 10% | 10% | 10% |
| **Initiator** | Benzildimethylketal | 2% | 2% | 2% | 2% | 2% | 2% | 2% | 2% | 2% | 2% |
| **Weichmacher** | Polyöl 130 | 15% | 15% | 15% | 15% | 15% | 15% | 12,5% | 10% | 0% | 0% |
| | Nisso PB B-1000 | 15% | 15% | 15% | 15% | 15% | 15% | 12,5% | 10% | 30% | 25% |
| **Additive** | | 1% | 1% | 1% | 1% | 1% | 1% | 1% | 1% | 1% | 1% |
| | | | | | | | | | | | |
| **Messwerte** | Härte nach DIN in Shore A | 62,2 | 67,7 | 64,0 | 63,5 | 65,5 | 67,4 | 69,3 | 72,6 | 65 | 73,5 |
| | Anisotropiefaktor | 1,0 | 4,2 | 2,7 | 1,0 | 1,1 | 1,0 | 1,3 | 2,0 | 1,0 | 1,5 |
| | Rohschichtplastizität (1 min.) in % | 10,7 | 8,7 | 9,3 | 14 | 25 | 48 | 11,9 | 10,7 | 13 | 11,2 |
| | MVR bei 100°C in $cm^3$/10 min. | 9,7 | 9,2 | 7,1 | 13,7 | 16,3 | >25 | 8,8 | 4,9 | 10,5 | 7,3 |

Tabelle 2: Rezeptur der fotopolymerisierbaren Schicht der Beispiele 1 bis 4 sowie Vergleichsbeispiel V4 (Angaben in Gew.-%) sowie erhaltene Messwerte: Schmelzflussindex und Rohschichtplastizität des fotopolymerisierbaren Flexodruckelementes; Härte und Anisotropiefaktor der fertigen Flexodruckform

| | Komponente | V4 | Beispiel1 | Beispiel 2 | Beispiel 3 | Beispiel 4 |
|---|---|---|---|---|---|---|
| **Bindemittel** | Kraton D-1102 | 57% | 57% | 52% | 57% | 52% |
| | Kraton D-1192 | | | | | |
| | Kraton D-1101 | | | | | |
| **Monomer** | Hexandioldiacrylat | 10% | 2% | 2% | 2% | 2% |
| | Tricyclodecandimethanoldiacrylat | | 8% | 13% | 8% | 13% |
| **Initiator** | Benzildimethylketal | 2% | 2% | 2% | 2% | 2% |
| **Weichmacher** | Polyöl 130 | 15% | 15% | 15% | 0% | 0% |
| | Nisso PB B-1000 | 15% | 15% | 15% | 30% | 30% |
| **Additive** | | 1% | 1% | 1% | 1% | 1% |
| | | | | | | |
| **Messwerte** | Härte (DIN) in ° Shore A | 63,5 | 68,1 | 75,1 | 72 | 79,3 |
| | Anisotropiefaktor | 1,0 | 1,0 | 1,0 | 1,0 | 1,0 |
| | Rohschichtplastizität (1 min.) | 14 | 9,9 | 14,7 | 9,8 | 14,3 |
| | MVR (bei 100°C) in $cm^3$/10 min. | 13,7 | 9,9 | 17,7 | 12,2 | 16,2 |

Die Ergebnisse in Tabelle 2. zeigen, dass die in den Beispielen 1 bis 4 hergestellten reliefbildenden Schichten im Vergleich zu der Schicht des Vergleichsbeispiels V1 deutlich härter sind. Die hergestellten Platten sind anisotropiefrei und zeigen eine akzeptable Rohschichtplastizität. Aufgrund eines Schmelzflussindex von > 5 $cm^3$/10 min sind die fotopolymerisierbaren Schichten nach dem in WO2004/092841 beschriebenen Verfahren rundverarbeitbar.

Dagegen führen Rezepturen mit einem Bindemittel mit höherem Styrolgehalt (V2 - V3; siehe Tabelle 1) zwar zu härten fotopolymerisierten Schichten, diese sind jedoch aufgrund ihres anisotropen Verhaltens nicht einsetzbar.

Versucht man die Härte der fotopolymerisierten Schichten durch einen höheren Monomergehalt (V4 bis V6, Tabelle 1) zu realisieren, so steigt die Rohschichtplastizität der Platte mit steigendem Monomeranteil überproportional. Ein Monomergehalt von 10 Gew.-% führt mit einer Rohschichtplastizität von 14% zu einer gerade noch akzeptablen Rohschichtplastizität, die Härte dieser fotopolymerisierten Schicht ist jedoch mit 63,5° Shore A nur unwesentlich höher. Bei höheren Monomergehalten werden die Rohschichtplastizität und damit der kalte Fluss der unbelichteten fotopolymerisierbaren Schicht zu groß. In der Summe resultiert aus diesen Versuchen keine Rezeptur für signifikant härtere Schichten.

Versuche, eine härtere Platte durch eine Reduktion des Weichmacheranteils (V7 bis V10, Tabelle 1) zu erreichen, führen zwar zu härteren fotopolymerisierten Schichten, diese werden jedoch bereits bei einer geringen Reduktion des Weichmacheranteils anisotrop. Der Einsatz eines hoch vinylgruppenhaltigen Weichmachers mit hohem Vinylgruppengehalt führt zwar zu einer etwas härteren fotopolymerisierten Schicht, eine Reduktion des Anteils dieses Weichmachers führt jedoch auch hier zu einer anisotropen Schicht. In der Summe resultiert aus diesen Versuchen keine Rezeptur für signifikant härtere Schichten.

*Druckversuche*

**Vergleichsbeispiel V11:**

Die in Vergleichsbeispiel V4 hergestellte fotopolymerisierbare Schicht wurde, wie in der allgemeinen Vorschrift beschrieben, zu einer endlos-nahtlosen Druckform verarbeitet. Als Haftschicht wurde dabei das Schaumklebeband Rogers SA 2520 (Fa. Rogers Corporation) verwendet. Der Andruck der hergestellten Druckform erfolgte auf einer Primaflex (Fa. Windmöller & Hölscher).

**Beispiele 5 und 6:**

Die in den Beispielen 1 und 3 hergestellten fotopolymerisierbaren Schichten wurden, wie in der allgemeinen Vorschrift beschrieben, zu endlos-nahtlosen Druckformen verarbeitet. Als Haftschicht wurde dabei das Schaumklebeband Rogers SA 2520 (Fa. Rogers Corporation) verwendet. Der Andruck der hergestellten Druckformen erfolgte auf einer Primaflex (Fa. Windmöller & Hölscher).

Ergebnisse: Die während des Andrucks erstellten Drückmuster (Testmuster mit Tonwertverläufen) wurden ausgewertet, die Ergebnisse bezüglich Flächendeckung (= Volltondichte = Maß für die Vollständigkeit der Übertragung der Druckfarbe auf das bedruckte Substrat; Bestimmung mittels Densitometer nach DIN16600), Tonwertumfang und der Tonwertzunahme im 30%-Raster sind in Tabelle 3 zusammengestellt.

Tabelle 3: Ergebnisse der Druckversuche

| Druckversuch Nr. | V11 | B5 | B6 |
|---|---|---|---|
| Verwendetes Flexodruckelement | V4 | Beispiel 1 | Beispiel 3 |
| Härte (DIN) in ° Shore A | 63,5 | 68,1 | 72 |
| Flächendeckung | 1,38 | 1,49 | 1,61 |
| Tonwertumfang | 3-97% | 1 - 98 % | 1 - 99 % |
| Tonwertzunahme im 30% Raster | + 12,3 % | + 12,8 % | + 12,5 % |

Wie Tabelle 3 zu entnehmen ist, wurde mit den Druckformen der Beispiele (B5 und B6) und der des Vergleichsbeispiels (V11) eine vergleichbare, niedrige Tonwertzunahme erhalten. Bei gleich bleibend niedriger Tonwertzunahme ist die Flächendeckung gemäß Beispielen B5 und B6 jedoch deutlich höher. Auch der Tonwertumfang gemäß Beispielen B5 und B6 ist höher als derjenige des Vergleichsbeispiels V11.

**Quellversuche**

Für die Quellversuche wurden jeweils 2 x 2 cm$^2$ große Stücke der fertigen Reliefschicht (also der belichteten Schicht) ohne Substrat und Trägerfolie in 10 ml einer Quellflüssigkeit gelegt. Die Quellzeit betrug jeweils 60 min. Es wurde jeweils die Schichtdicke vor und nach 60 min quellen bestimmt. Als Quellflüssigkeit (1) wurde ein Gemisch aus Ethanol, Ethoxypropanol und Essigester (50 / 45 / 5) verwendet. Hierbei handelt es sich um typische Lösemittel, welche in Flexodruckfarben verwendet werden. Als Quellflüssigkeit (2) wurde Hexandioldiacrylat verwendet. Hierbei handelt es sich um einen typischen Bestandteil UV-härtbarer Druckfarben. Die Ergebnisse sind in Tabelle 4 dargestellt.

Tabelle 4: Ergebnisse der Quellversuche (Schichtdicke vor Quellversuch 100 %)

| | relative Schichtdicke | |
|---|---|---|
| Reliefschicht gemäß | V4 | Beispiel 1 |
| Quellmedium | | |
| (1) Ethanol / Ethoxypropanol / Essigester (50 / 45 / 5) | 103 % | 101 % |
| (2) Hexandioldiacrylat | 107 % | 105 % |

Die Ergebnisse zeigen, dass die erfindungsgemäße Flexodruckplatte gemäß Beispiel 1 sowohl im Quellmedium 1 als auch im Quellmedium 2 weniger stark quillt als die Flexodruckplatte gemäß Vergleichsbeispiel 4.

**Patentansprüche**

1.   Fotopolymerisierbares Flexodruckelement zur Herstellung von harten Flexodruckformen, mindestens umfassend

- einen dimensionsstabilen Träger,
- eine fotopolymerisierbare, reliefbildende Schicht enthaltend, jeweils bezogen auf die Gesamtmenge aller Komponenten der reliefbildenden Schicht,

■ 40 bis 90 Gew.-% eines Bindemittels enthaltend mindestens ein thermoplastisch-elastomeres Blockcopolymer umfassend mindestens einen aus einem Alkenylaromaten gebildeten Block und mindestens einen aus einem 1,3-Dien gebildeten Block,
■ 0,1 bis 20 Gew.-% ethylenisch ungesättigte Monomere M,
■ 0,1 bis 5 Gew.-% Fotoinitiator und
■ 1 bis 40 Gew.-% Weichmacher,

**dadurch gekennzeichnet, dass**
die fotopolymerisierbare, reliefbildende Schicht als Monomere M mindestens ein Di(meth)acrylat M1 der allgemeinen Formel $H_2C=CR-C(O)O-R^2-OC(O)-CR=CH_2$, wobei R für H oder eine Methylgruppe steht, und es sich bei $R^2$ um einen zweiwertigen alicyclischen Kohlenwasserstoffrest mit 10 bis 20 Kohlenstoffatomen handelt, enthält und daneben gegebenenfalls noch ein oder mehrere weitere Monomere M2 enthalten kann, und die belichtete, fotopolymerisierte reliefbildende Schicht eine Härte von mindestens 66° Shore A aufweist

2. Fotopolymerisierbares Flexodruckelement nach Anspruch 1, **dadurch gekennzeichnet, dass** der Anisotropiefaktor der belichteten, fotopolymerisierten, reliefbildenden Schicht weniger als 1,2 beträgt.

3. Fotopolymerisierbares Flexodruckelement Anspruch 1 oder 2, **dadurch gekennzeichnet, dass** die fotopolymerisierbare, reliefbildende Schicht als Di(meth)acrylat M1 Tricyclodecandimethanoldi(meth)acrylat enthält.

4. Fotopolymerisierbares Flexodruckelement nach einem der Ansprüche 1 bis 3, **dadurch gekennzeichnet, dass** die reliefbildende Schicht 2 bis 15 Gew. % Di(meth)acrylate M1 enthält.

5. Fotopolymerisierbares Flexodruckelement nach einem der Ansprüche 1 bis 4 **dadurch gekennzeichnet, dass** die fotopolymerisierbare, reliefbildende Schicht weitere Monomere M2 enthält, wobei das Gewichtsverhältnis der Monomere M1 : M2 mindestens 1 : 1 beträgt.

6. Fotopolymerisierbares Flexodruckelement nach einem der Ansprüche 1 bis 5, **dadurch gekennzeichnet, dass** die fotopolymerisierbare, reliefbildende Schicht als thermoplastisch-elastomeres Blockcopolymer ein Styrol-Butadien-Blockcopolymer enthält.

7. Fotopolymerisierbares Flexodruckelement nach einem der Ansprüche 1 bis 6, **dadurch gekennzeichnet, dass** die fotopolymerisierbare, reliefbildende Schicht als thermoplastisch-elastomeres Blockcopolymer ein Styrol-Isopren-Blockcopolymer enthält.

8. Fotopolymerisierbares Flexodruckelement nach einem der Ansprüche 1 bis 7, **dadurch gekennzeichnet, dass** die Rohschichtplastizität der unbelichteten fotopolymerisierbaren, reliefbildenden Schicht im Bereich von 5 bis 16 % liegt.

9. Fotopolymerisierbares Flexodruckelement nach einem der Ansprüche 1 bis 8, **dadurch gekennzeichnet, dass** der Schmelzflussindex bei 100 °C und einem Auflagegewicht von 5 kg der unbelichteten fotopolymerisierbaren, reliefbildenden Schicht im Bereich von 5 bis 50 cm$^3$/10 min liegt.

10. Fotopolymerisierbares, zylindrisches, endlos-nahtloses Flexodruckelement, umfassend einen Hohlzylinder, auf dem Hohlzylinder eine Haftschicht, gegebenenfalls eine elastomere Trägerschicht, und eine fotopolymerisierbare reliefbildende Schicht wie in einem der Ansprüche 1 bis 9 definiert.

11. Schichtenverbund zur Herstellung eines fotopolymerisierbaren, zylindrischen, endlos-nahtlosen Flexodruckelements, umfassend eine abziehbare temporäre Trägerfolie, gegebenenfalls eine elastomere Trägerschicht, eine fotopolymerisierbare, reliefbildende Schicht wie in einem der Ansprüche 1 bis 9 definiert, sowie eine abziehbare temporäre Deckfolie.

12. Verwendung eines Schichtenverbundes nach Anspruch 11 zur Herstellung eines fotopolymerisierbaren, zylindrischen, endlos-nahtlosen Flexodruckelements oder einer zylindrischen, endlos-nahtlosen Flexodruckform.

13. Verfahren zur Herstellung eines zylindrischen, endlos-nahtlosen fotopolymerisierbaren Flexodruckelements nach Anspruch 10 mit den Schritten

a) Bereitstellen eines Schichtenverbundes umfassend eine abziehbare temporäre Trägerfolie, gegebenenfalls eine elastomere Trägerschicht, eine fotopolymerisierbare, reliefbildende Schicht wie in einem der Ansprüche 1 bis 9 definiert, und eine abziehbare temporäre Deckfolie,

b) Zurechtschneiden der zu verbindenden Kanten des Schichtenverbundes,

c) Aufschieben und Arretieren eines Hohlzylinders auf einen drehbar gelagerten Trägerzylinder,

d) Aufbringen einer Haftschicht auf die äußere Fläche des Hohlzylinders,

e) Aufbringen des zurechtgeschnittenen Schichtenverbundes aus der fotopolymerisierbaren reliefbildenden Schicht, gegebenenfalls der elastomeren Trägerschicht und der abziehbaren Deckfolie nach Abziehen der temporären Trägerfolie mit der fotopolymerisierbaren reliefbildenden Schicht bzw. der elastomeren Trägerschicht auf den mit der Haftschicht versehenen Hohlzylinder,

f) Abziehen der Deckfolie von der Schicht aus fotopolymerisierbarem Material,

g) Verbinden der Schnittkanten bei einer Temperatur unterhalb der Schmelztemperatur der fotopolymerisierbaren Schicht, indem man die Oberfläche der fotopolymerisierbaren Schicht auf dem Hohlzylinder mit einer sich drehenden Kalanderwalze in Kontakt bringt, bis die Schnittkanten miteinander verbunden sind,

h) Abziehen des bearbeiteten Hohlzylinders vom Trägerzylinder.

**14.** Verfahren nach Anspruch 13, **dadurch gekennzeichnet, dass** als Haftschicht ein doppelseitiges Klebeband eingesetzt wird.

**15.** Verfahren zur Herstellung eines fotopolymerisierbaren Flexodruckelements nach einem der Ansprüche 1 bis 9, oder eines Schichtverbundes nach Anspruch 11, mit den Schritten

I intensives Vermischen der Komponenten der fotopolymerisierbaren, reliefbildenden Schicht in einem Extruder unter Erwärmen zu einer geschmolzenen fotopolymerisierbaren Masse,

II Austragen der geschmolzenen fotopolymerisierbaren Masse durch eine Breitschlitzdüse zwischen eine Trägerfolie, die gegebenenfalls mit einer elastomeren Trägerschicht beschichtet sein kann, und eine Deckfolie und

III Kalandrieren des gebildeten Schichtenverbundes.

**16.** Verfahren zur Herstellung einer zylindrischen, endlos-nahtlosen Flexodruckform mit den Schritten a) bis h) nach Anspruch 13 oder 14 mit dem zusätzlichen Schritt

i) bildmäßiges Belichten der fotopolymerisierbaren reliefbildenden Schicht und Entwickeln der belichteten reliefbildenden Schicht, oder vollflächiges Belichten der fotopolymerisierbaren, reliefbildenden Schicht und Eingravieren des Druckreliefs in die belichtete, reliefbildende Schicht mit einem Laser.

**Claims**

**1.** A photopolymerisable flexographic printing element for producing hard flexographic printing formes, at least comprising

- a dimensionally stable substrate,
- a photopolymerisable, relief-forming layer containing, in each case based on the total quantity of all components of the relief-forming layer,

• 40 to 90 % by weight of a binder containing at least one thermoplastic elastomeric block copolymer comprising at least one block formed from an alkenyl aromatic and at least one block formed from a 1,3-diene,
• 0.1 to 20 % by weight of ethylenically unsaturated monomers M,
• 0.1 to 5 % by weight of photoinitiator and
• 1 to 40 % by weight of plasticiser,

**characterised in that**
the photopolymerisable, relief-forming layer contains at least one di(meth)acrylate M1 of the general formula $H_2C=CR-C(O)O-R^2-OC(O)-CR=CH_2$ as monomers M, where R represents H or a methyl group and $R^2$ is a divalent alicyclic hydrocarbon residue containing 10 to 20 carbon atoms, and, in addition, can optionally also contain one or more further monomers M2, and the exposed, photopolymerised relief-forming layer has a hardness of at least 66° Shore A.

**2.** A photopolymerisable flexographic printing element according to Claim 1, **characterised in that** the anisotropy factor of the exposed, photopolymerised, relief-forming layer is less than 1.2.

3. A photopolymerisable flexographic printing element according to Claim 1 or 2, **characterised in that** the photopolymerisable, relief-forming layer contains tricyclodecanedimethanoldi(meth)acrylate as a di(meth)acrylate M1.

4. A photopolymerisable flexographic printing element according to one of Claims 1 to 3, **characterised in that** the relief-forming layer contains 2 to 15 % by weight of di(meth)acrylate M1.

5. A photopolymerisable flexographic printing element according to one of Claims 1 to 4, **characterised in that** the photopolymerisable, relief-forming layer contains further monomers M2, with the weight ratio of the monomers M1: M2 being at least 1:1.

6. A photopolymerisable flexographic printing element according to Claims 1 to 5, **characterised in that** the photopolymerisable, relief-forming layer contains a styrene-butadiene block copolymer as a thermoplastic elastomeric block copolymer.

7. A photopolymerisable flexographic printing element according to one of Claims 1 to 6, **characterised in that** the photopolymerisable, relief-forming layer contains a styrene-isoprene block copolymer as a thermoplastic elastomeric block copolymer.

8. A photopolymerisable flexographic printing element according to one of Claims 1 to 7, **characterised in that** the raw layer plasticity of the unexposed photopolymerisable, relief-forming layer is in the range of 5 to 16 %.

9. A photopolymerisable flexographic printing element according to one of Claims 1 to 8, **characterised in that**, at 100°C and with an applied weight of 5 kg, the melt flow index of the unexposed photopolymerisable, relief-forming layer is in the range of 5 to 50 cm$^3$/10 min.

10. A photopolymerisable, cylindrical, continuously seamless flexographic printing element, comprising a hollow cylinder, a bonding layer on the hollow cylinder, optionally an elastomeric substrate layer and a photopolymerisable relief-forming layer as defined in one of Claims 1 to 9.

11. A layer composite for producing a photopolymerisable, cylindrical, continuously seamless flexographic printing element, comprising a removable temporary substrate film, optionally an elastomeric substrate layer, a photopolymerisable, relief-forming layer as defined in one of Claims 1 to 9, and a removable temporary cover film.

12. The use of a layer composite according to Claim 11 for producing a photopolymerisable, cylindrical, continuously seamless flexographic printing element or a cylindrical, continuously seamless flexographic printing forme.

13. A process for producing a cylindrical, continuously seamless, photopolymerisable flexographic printing-element according to Claim 10 having the steps

a) providing a layer composite comprising a removable temporary substrate film, optionally an elastomeric substrate layer, a photopolymerisable, relief-forming layer as defined in one of Claims 1 to 9, and a removable temporary cover film,
b) trimming the edges of the layer composite which are to be connected,
c) pushing a hollow cylinder onto a rotatably mounted substrate cylinder and locking it thereon,
d) applying a bonding layer to the outer face of the hollow cylinder,
e) applying the trimmed layer composite comprising the photopolymerisable relief-forming layer, optionally the elastomeric substrate layer and the removable cover film to the hollow cylinder provided with the bonding layer after removing the temporary substrate film with the photopolymerisable relief-forming layer or the elastomeric substrate layer,
f) removing the cover film from the layer of photopolymerisable material,
g) connecting the trimmed edges at a temperature below the melting temperature of the photopolymerisable layer, whereby the surface of the photopolymerisable layer on the hollow cylinder is brought into contact with a rotating calendar roll until the trimmed edges are connected together,
h) removing the processed hollow cylinder from the substrate cylinder.

14. A process according to Claim 13, **characterised in that** a double-sided adhesive strip is used as the bonding layer.

15. A process for producing a photopolymerisable flexographic printing element according to one of Claims 1 to 9, or a layer composite according to Claim 11, having the steps

   I thoroughly mixing the components of the photopolymerisable, relief-forming layer in an extruder whilst heating to produce a molten photopolymerisable mass,
   II discharging the molten photopolymerisable mass through a sheet die between a substrate film, which can optionally be coated with an elastomeric substrate layer, and a cover film and
   III calendaring the layer composite which is formed.

16. A process for producing a cylindrical, continuously seamless flexographic printing forme having the steps a) to h) according to Claim 13 or 14 with the additional step

   i) exposing the photopolymerisable relief-forming layer image-wise and developing the exposed relief-forming layer, or exposing the photopolymerisable, relief-forming layer over its full surface and engraving the print relief into the exposed, relief-forming layer by means of a laser.

## Revendications

1. Elément d'impression flexographique photopolymérisable pour la réalisation de formes d'impression flexographique dures, comprenant au moins

   - un support à dimensions stables,
   - une couche photopolymérisable formant un relief, contenant, à chaque fois par rapport à la quantité totale de tous les composants de la couche formant un relief,

     - 40 à 90% en poids d'un liant contenant au moins un copolymère à blocs thermoplastique-élastomère, comprenant au moins un bloc formé à partir d'un alcénylaromatique et au moins un bloc formé à partir d'un 1,3-diène,
     - 0,1 à 20% en poids de monomères M éthyléniquement insaturés,
     - 0,1 à 5% en poids de photo-initiateur et
     - 1 à 40% en poids de plastifiant,

   **caractérisé en ce que** la couche photopolymérisable formant un relief contient, comme monomère M, au moins un di(méth)acrylate M1 de formule générale $H_2C=CR\text{-}C(O)O\text{-}R^2\text{-}OC(O)\text{-}CR=CH_2$, R représentant H ou un groupe méthyle, et où il s'agit, pour $R^2$, d'un radical hydrocarboné alicyclique divalent comprenant 10 à 20 atomes de carbone et peut en outre le cas échéant encore contenir un ou plusieurs autres monomères M2, et la couche photopolymérisable formant un relief, éclairée, présente une dureté d'au moins 66° Shore A.

2. Elément d'impression flexographique photopolymérisable selon la revendication 1, **caractérisé en ce que** le facteur d'anisotropie de la couche photopolymérisable formant un relief, éclairée, est inférieur à 1,2.

3. Elément d'impression flexographique photopolymérisable selon la revendication 1 ou 2, **caractérisé en ce que** la couche photopolymérisable formant un relief contient comme di(méth)acrylate M1 du di(méth)acrylate de tricyclodécanediméthanol.

4. Elément d'impression flexographique photopolymérisable selon l'une quelconque des revendications 1 à 3, **caractérisé en ce que** la couche formant un relief contient 2 à 15% en poids de di(méth)acrylates M1.

5. Elément d'impression flexographique photopolymérisable selon l'une quelconque des revendications 1 à 4, **caractérisé en ce que** la couche photopolymérisable formant un relief contient d'autres monomères M2, le rapport pondéral des monomères M1:M2 valant au moins 1:1.

6. Elément d'impression flexographique photopolymérisable selon l'une quelconque des revendications 1 à 5, **caractérisé en ce que** la couche photopolymérisable formant un relief contient comme copolymère à blocs thermoplastique-élastomère, un copolymère à blocs de styrène-butadiène.

7. Elément d'impression flexographique photopolymérisable selon l'une quelconque des revendications 1 à 6, **carac-**

**térisé en ce que** la couche photopolymérisable formant un relief contient comme copolymère à blocs thermoplastique-élastomère, un copolymère à blocs de styrène-isoprène.

8.  Elément d'impression flexographique photopolymérisable selon l'une quelconque des revendications 1 à 7, **caractérisé en ce que** la plasticité de la couche brute photopolymérisable formant un relief, non éclairée, se situe dans la plage de 5 à 16%.

9.  Elément d'impression flexographique photopolymérisable selon l'une quelconque des revendications 1 à 8, **caractérisé en ce que** l'indice de fluidité à chaud à 100°C et sous un poids de 5 kg de la couche photopolymérisable formant un relief, non éclairée, se situe dans la plage de 5 à 50 cm$^3$/10 min.

10. Elément d'impression flexographique photopolymérisable, cylindrique, sans fin, sans joint, comprenant un cylindre creux, une couche adhésive sur le cylindre creux, le cas échéant une couche support élastomère et une couche photopolymérisable formant un relief, telle que définie dans l'une quelconque des revendications 1 à 9.

11. Composite à couches pour la fabrication d'un élément d'impression flexographique photopolymérisable, cylindrique, sans fin, sans joint, comprenant une feuille support temporaire, pouvant être enlevée, le cas échéant une couche support élastomère, une couche photopolymérisable formant un relief, telle que définie dans l'une quelconque des revendications 1 à 9 ainsi qu'une feuille de recouvrement temporaire, pouvant être enlevée.

12. Utilisation d'un composite à couches selon la revendication 11 pour la fabrication d'un élément d'impression flexographique photopolymérisable, cylindrique, sans fin, sans joint ou d'une forme d'impression flexographique cylindrique sans fin, sans joint.

13. Procédé pour la fabrication d'un élément d'impression flexographique photopolymérisable, cylindrique, sans fin, sans joint selon la revendication 10, comprenant les étapes

    a) mise à disposition d'un composite à couches comprenant une feuille support temporaire, pouvant être enlevée, le cas échéant une couche support élastomère, une couche photopolymérisable formant un relief, telle que définie dans l'une quelconque des revendications 1 à 9 ainsi qu'une feuille de recouvrement temporaire, pouvant être enlevée,
    b) découpe à dimension des bords à assembler du composite à couches,
    c) glissement et blocage d'un cylindre creux sur un cylindre support logé de manière à pouvoir tourner,
    d) application d'une couche adhésive sur la surface extérieure du cylindre creux,
    e) application du composite à couche coupé à dimension constitué par la couche photopolymérisable formant un relief, le cas échéant de la couche support élastomère et de la couche de recouvrement pouvant être enlevée, après élimination de la feuille support temporaire, en plaçant la couche photopolymérisable formant un relief ou, selon le cas, la couche support élastomère sur le cylindre creux muni de la couche adhésive,
    f) élimination de la feuille de recouvrement de la couche en matériau photopolymérisable,
    g) assemblage des bords de coupe à une température inférieure à la température de fusion de la couche photopolymérisable, en ce qu'on met en contact la surface de la couche photopolymérisable sur le cylindre creux avec un cylindre de calandrage rotatif, jusqu'à ce que les bords de coupe soient assemblés les uns aux autres,
    h) élimination du cylindre creux traité du cylindre support.

14. Procédé selon la revendication 13, **caractérisé en ce qu'**on utilise comme couche adhésive une bande adhésive double face.

15. Procédé pour la fabrication d'un élément d'impression flexographique photopolymérisable selon l'une quelconque des revendications 1 à 9 ou d'un composite à couches selon la revendication 10, comprenant les étapes

    I mélange intensif des composants de la couche photopolymérisable formant un relief dans une extrudeuse en chauffant en une masse photopolymérisable fondue,
    II distribution de la masse photopolymérisable fondue par une filière à fente large entre une feuille support, qui peut le cas échéant être revêtue d'une couche support élastomère, et une feuille de recouvrement et
    III calandrage du composite à couches formé.

16. Procédé pour la fabrication d'un élément d'impression flexographique cylindrique, sans fin, sans joint comprenant les étapes a) à h) selon la revendication 13 ou 14, comprenant l'étape supplémentaire

    i) éclairage conforme à une image de la couche photopolymérisable formant un relief et développement de la couche formant un relief, éclairée ou éclairage sur toute la surface de la couche photopolymérisable formant un relief et gravure du relief d'impression dans la couche formant un relief, éclairée, à l'aide d'un laser.

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 2004092841 A
- EP 1516745 A
- EP 654150 A
- EP 1069475 A
- EP 1072953 A
- EP 1070989 A
- EP 1158365 A
- US 3264103 A
- US 5175072 A
- WO 9614603 A
- WO 0188615 A
- WO 0139897 A
- EP 463016 A
- WO 2005113240 A

**In der Beschreibung aufgeführte Nicht-Patentliteratur**

- Technik des Flexodrucks. Coating Verlag, 1999, 73